# EUROPÄISCHE PATENTANMELDUNG

(11) **EP 4 524 285 A1**
(43) Veröffentlichungstag der Anmeldung: **19.03.2025**
(21) Anmeldenummer: 24195369.4
(22) Anmeldetag: 20.08.2024
(51) Int. Cl.: C23C 16/04, C23C 16/455, C23C 16/511, C23C 16/54

(54) **BESCHICHTUNGSSTATION FÜR DIE GLEICHZEITIGE BESCHICHTUNG VON MEHREREN BEHÄLTERN IN EINEM AUF DER BESCHICHTUNGSSTATION ABLAUFENDEN BESCHICHTUNGSVERFAHREN**

(30) Priorität: 28.08.2023 DE 102023123027
(71) Anmelder: KHS GmbH, 44143 Dortmund (DE)
(72) Erfinder: Herbort, Michael, 44143 Dortmund (DE); Vogelsang, Andreas, 44143 Dortmund (DE); Brzezinski, Milosz, 44143 Dortmund (DE)
(74) Vertreter: Eisenführ Speiser

(57) **Zusammenfassung**

Die Erfindung betrifft eine Beschichtungsstation (1) für die gleichzeitige Innenbeschichtung von mehreren Behältern (5), wobei die Beschichtungsstation (1) eine Beschichtungskammer (17) aufweist, die in einen geöffneten und einen geschlossenen Zustand überführbar ist und in die die Behälter (5) anordenbar sind. Die Beschichtungsstation (1) weist eine Stationsleitung (70) mit einem Stationsventil (72) auf für den ventilbeherrschten Anschluss an wenigstens eine Prozessgasquelle (44), wobei die Beschichtungsstation (1) für jeden Behälter (5) eine zugeordnete Gaslanze (36) aufweist, die in einer Beschichtungsstellung in das Behälterinnere hineinragt und die über die Stationsleitung (70) mit der Prozessgasquelle (44) verbindbar ist, wobei innerhalb der Station (1) kammerseitig des Stationsventils (72) eine von der Stationsleitung (70) abgehende Zuführleitung (71, 76a, 76b, 78) für das Prozessgas zu den Gaslanzen (36) verläuft, wobei die Zuführleitung an den Gaslanzen (36) endet, und ist dadurch gekennzeichnet, dass sich die Zuführleitung an wenigstens einer Zweigstelle (55a, 55b) in Teilleitungen (76a, 76b, 78) aufteilt, wobei jede der Teilleitungen (76a, 76b, 78) jeweils zu einer der Gaslanzen (36) verläuft, und wobei Länge und Durchmesser der Zuführleitung (71) und der Teilleitungen (76a, 76b, 78) so gewählt ist, dass der Strömungswiderstand des Prozessgases ausgehend von dem Stationsventil (72) und durch jede Teilleitung (76a, 76b, 78) hindurch bis zur Gaslanze (36) gleich ist.

## Beschreibung

Die Erfindung betrifft eine Beschichtungsstation nach dem Oberbegriff von Anspruch 1. In der Beschichtungsstation sollen gleichzeitig mehrere Behälter nach einem Beschichtungsverfahren beschichtet werden. Ein typisches und bevorzugtes Beispiel ist die Innenbeschichtung von Behältern. Ein typischer und bevorzugter Behälter ist z.B. eine Flasche aus einem thermoplastischen Kunststoff, z.B. aus PET. Insbesondere und bevorzugt ist gedacht an Beschichtungen, die mittels eines PECVD-Verfahrens aufgebracht werden, insbesondere mittels eines mikrowelleninduzierten PECVD-Verfahrens.

Ein in der Praxis häufiger Fall ist, dass ein Behälter mit einer Innenbeschichtung versehen werden soll, z.B. um Barriereeigenschaften des Behältermaterials zu verbessern, z.B. gegen Durchtritt von Sauerstoff nach innen oder von Kohlendioxid nach außen.

Bei den genannten plasmabasierten Beschichtungsverfahren sind zur Ermöglichung der Ausbildung eines Plasmas Unterdruckbedingungen im Bereich der zu beschichtenden Behälter einzustellen. Bei einer Innenbeschichtung müssen im Behälterinneren Unterdruckbedingungen vorliegen, die eine Plasmaerzeugung erlauben. Bei einer Außenbeschichtung müssen entsprechend um den Behälter herum Unterdruckbedingungen eingestellt werden. Es sind im Stand der Technik vielfältige Verfahren und Vorrichtungen bekannt, um solche Unterdruckbedingungen einstellen zu können, um dann Beschichtungen abzuscheiden. Es sind im Stand der Technik ebenfalls in vielfältiger Art plasmabasierte Beschichtungsverfahren und Vorrichtungen bekannt, auf denen diese Verfahren ablaufen. Rein Beispielhaft seien die WO03/100125 A1, die WO03/100121 A2, die EP 1 954 851 B1, die EP 1 773 512 B1 und die WO03/100120 A2 genannt. Von einer grundsätzlichen Beschreibung dieser Verfahren und Vorrichtungen kann daher abgesehen werden.

Bei Behältern, z.B. bei dünnwandigen Kunststoffflaschen, z.B. aus PET, die ein typisches Beispiel für Behälter sind, auf die sich die Erfindung bezieht, und die nicht genügend Eigenstabilität aufweisen, um den einzustellenden Unterdruckbedingungen und insbesondere dem Druckunterschied zwischen dem Inneren und dem Äußeren standzuhalten, hat sich bewährt, um den Behälter herum eine Kammer anzuordnen und den zu beschichtenden Behälter in diese Kammer einzuführen und in der Kammer zu beschichten. In der vorliegenden Anmeldung wird diese Kammer als Beschichtungskammer bezeichnet. Der Behälter wird dabei abgedichtet innerhalb der Kammer gehalten und die Kammer selber ist gegenüber der Umgebung abgedichtet. Das abgedichtete Halten des Behälters in der Kammer umfasst einerseits, dass das Behälterinnere gegenüber der umgebenden Kammer abgedichtet ist, aber auch gegenüber der Umgebung der Kammer. Es kann dann innerhalb des Behälters und in der den Behälter umgebenden Kammer jeweils ein Unterdruck eingestellt werden, wobei beide Drücke unterschiedlich ausgeführt sein können. Wenn z.B. eine Außenbeschichtung am Behälter aufgebracht werden soll, ist der Unterdruck in der den Behälter umgebenden Kammer so einzustellen, dass ein Beschichtungsvorgang stattfinden kann, dass also z.B. ein Plasma entstehen kann, während der Druck im Behälterinneren so einzustellen ist, dass bei Einstellen des Unterdrucks in der umgebenden Kammer der Behälter aufgrund eines Druckunterschiedes innen zu außen nicht beschädigt wird. Es ist dabei durchaus gewünscht, dass der Druck im Inneren abweicht vom Außendruck, damit im Inneren zuverlässig kein Plasma entstehen kann. Soll hingegen das Behälterinnere beschichtet werden, so ist im Behälterinneren ein Unterdruck einzustellen, der einen solchen Beschichtungsvorgang ermöglicht, also z.B. das Ausbilden eines Plasmas, während der Druck in der umgebenden Kammer so einzustellen ist, dass der Unterdruck im Behälterinneren den Behälter nicht beschädigt. Auch dies ist im Stand der Technik vielfältig bekannt, z.B. aus den zuvor genannten Dokumenten. Das in diesem Absatz für einen Behälter zu den Unterdruckbedingungen Beschriebene muss bei den gattungsgemäßen Beschichtungsstationen für die zeitgleiche Beschichtung mehrerer Behälter für jeden dieser mehreren Behälter ausgeführt werden Auch dies erfolgt in der Regel zeitgleich und nach Möglichkeit für alle Behälter in identischer Weise, um Unterschiede zwischen den Behältern zu vermeiden, denn solche Unterschiede könnten zu unterschiedlichen Beschichtungsergebnissen führen. Angestrebt ist aber, dass möglichst für alle Behälter gleiche Beschichtungen entstehen.

Es sind im Stand der Technik Beschichtungsstationen bekannt, in denen nicht nur ein einzelner Behälter beschichtet wird, sondern in denen zeitgleich mehrere Behälter beschichtet werden. Bekannt ist auch, dass diese Beschichtungsstationen eine Beschichtungskammer aufweisen für das Einstellen der zuvor erklärten Unterdruckbedingungen, wobei diese Kammer zur Aufnahme mehrerer Behälter ausgebildet ist. Bekannt ist auch, dass eine solche Kammer in Teilkammern unterteilt sein kann und in jeder Teilkammer jeweils ein Behälter aufgenommen ist. WO 03/100125 A1 offenbart z.B. in ihrer Figur 14 eine Beschichtungsstation, in der zeitgleich zwei Behälter beschichtet werden können, wobei die Beschichtungskammer hierzu von einer mittleren Trennwand in zwei Teilkammern unterteilt ist. WO 03/100121 A2 zeigt ebenfalls eine solche unterteilte Beschichtungskammer, siehe z.B. Figuren 1 und 2, sie zeigt auch eine Beschichtungskammer ohne eine solche Unterteilung, in der also zwei Behälter ohne dazwischenliegende Trennwand in der gleichen Kammer angeordnet sind, siehe z.B. Figur 3. Diese beiden Dokumente und die EP 1 954 851 B1, die EP 1 773 512 B1 und die WO 03/100120 A2 offenbaren überdies weitere technische Details zu Beschichtungsverfahren und zu dazu dienenden Vorrichtungen.

Zur Ausbildung der Beschichtungen werden Ausgangsprodukte in gasförmiger Form bereitgestellt und zum Beschichtungsort geführt. Nachfolgend werden diese gasförmigen Ausgangsprodukte als Prozessgase bezeichnet. Auch das Bereitstellen und Zuführen benötigter Prozessgase ist in dem oben angesprochenen Stand der Technik beschrieben. Die vorliegende Anmeldung beschäftigt sich nicht mit der Prozessgaserzeugung, sondern mit der Prozessgaszufuhr zu den Beschichtungsstationen, in denen mehrere Behälter gleichzeitig beschichtet werden sollen. Erforderlich ist also die zeitgleiche Zufuhr des Prozessgases zu mehreren Behältern, was zu besonderen Herausforderungen führt. Insbesondere geht es um die zeitgleiche Zuführung von Prozessgasen in mehrere Behälterinnenräume hinein, um die Behälterinnenwände mit einer Beschichtung zu versehen, z.B. mit einer Schicht mit Barriereeigenschaften. Für dieses Zuführen von Prozessgasen in mehrere Behälterinnenräume hinein ist unerheblich, ob diese Behälter in einer Beschichtungskammer mit Teilkammern angeordnet sind, oder ob diese Behälter ohne Trennwände in einer gemeinsamen Kammer angeordnet sind. Insofern umfasst der in den Ansprüchen verwendete Begriff der Beschichtungskammer beide Möglichkeiten.

Für das Erreichen hoher Produktionsraten sowie für das Erreichen einer guten und gleichbleibenden Beschichtungsqualität ist die Zufuhr der Prozessgase von besonderer Relevanz.

Kommerzielle Maschinen zur Beschichtung von Behältern sind häufig als Maschinen rotierender Bauart ausgeführt. Ein drehbar gelagertes Beschichtungsrad wird z.B. kontinuierlich drehend angetrieben und kontinuierlich werden zu beschichtende Behälter auf das Beschichtungsrad übergeben, in Beschichtungskammern eingesetzt, beim weiteren Umlauf des Rades mit Prozessgasen beschickt, Beschichtungen abgeschieden und die beschichteten Behälter von dem umlaufenden Rad wieder entnommen. Zu diesem Zweck sind umfangsbeabstandet und mit dem Beschichtungsrad umlaufend mehrere Beschichtungsstationen angeordnet, die gemäß der vorliegenden Erfindung jeweils zeitgleich mehrere Behälter aufnehmen und beschichten. Einige der oben angesprochenen Dokumente zum Stand der Technik beschreiben solche Maschinen rotierender Bauart und dass und wie z.B. Prozessgase in stationär angeordneten Prozessgaserzeugern bereitgestellt und über Drehverteiler auf die Beschichtungsräder übertragen werden, und wie z.B. stationär Vakuumpumpen angeordnet werden und wie über Drehverteiler die Pumpleistung zu den umlaufenden Beschichtungsstationen geführt wird. Dieser Stand der Technik offenbart auch, wie Übergabe- und Entnahmevorgänge der Behälter erfolgen und wie z.B. die Beschichtungskammern der umlaufend angeordneten Stationen geöffnet und geschlossen werden können, um Übergabevorgänge auszuführen. Die Erfindung ist mit all ihren Ausführungsvarianten insbesondere auf solche Maschinen rotierender Bauart gerichtet, ohne aber Maschinen auszuschließen, die nicht nach der rotierenden Bauart ausgeführt sind, sondern z.B. als Linearmaschinen.

Es ist weiterhin bekannt, während des Beschichtungsverfahrens nicht nur eine, sondern mehrere Schichten abzuschneiden, z.B. zunächst eine Haftvermittlerschicht, dann eine Barriereschicht und schließlich eine Schutzschicht. Es sind auch andere Schichtaufbauten bekannt. Zum Erreichen dieser unterschiedlichen Schichten wird während des Beschichtungsvorganges das in die Behälter geführte Prozessgas verändert, z.B. wird zwischen alternativen Prozessgasquellen umgeschaltet oder die Zusammensetzung des Prozessgases wird kontinuierlich verändert. Auch diese Vorgänge sollen möglichst für alle Behälter gleich und gleichzeitig erfolgen, um zu einem gleichen Beschichtungsergebnis zu kommen.

Es ist im Stand der Technik bekannt, dass für unterschiedliche Prozessgase bzw. Prozessgasmischungen jeweils eine eigene ventilbeherrschte Prozessgasleitung vorgesehen ist und alle diese Prozessgasleitungen in eine Stationsleitung münden, welche von einem Stationsventil beherrscht wird und welche die Beschichtungsstation mit Prozessgas versorgt. Es wird also nicht über mehrere Stationsleitungen jeweils ein unterschiedliches Prozessgas zugeführt, sondern es gibt eine Stationsleitung, in der gegebenenfalls zeitlich nacheinander Prozessgase unterschiedlicher Zusammensetzung zugeführt werden. Die oben genannten ventilbeherrschten Prozessgasleitungen für die Prozessgase leiten die Prozessgase in diese besagte Stationsleitung. Nur bei geöffnetem Stationsventil und Öffnen eines der Ventile, die eine der Prozessgasleitungen beherrschen, gelangt das entsprechende Prozessgas in den Behälter bzw. verallgemeinert gesprochen an den Beschichtungsort. Bekannt ist zudem, zusätzlich eine sogenannte Bypassleitung vorzusehen, welche ebenfalls ventilbeherrscht ist. Diese Bypassleitung ist vorgesehen, um Prozessgas kontinuierlich abführen zu können, wenn in der Station kein Prozessgas in die Behälter einzuführen bzw. zum Beschichtungsort zu führen ist, z.B. weil gerade ein Behälterwechsel erfolgt. In diesen Phasen soll dennoch ein kontinuierlicher Prozessgasstrom erfolgen, damit das bereitgestellte Prozessgas, das z.B. in Verdampfern aus flüssigen Ausgangskomponenten verdampft und z.B. mit anderen gasförmigen Komponenten vermischt wird, in einer gleichbleibenden Zusammensetzung und mit gleichbleibenden Druckverhältnissen schnell zur Verfügung steht, sobald eine Kammer neu mit Behältern bestückt und für den nächsten Beschichtungsvorgang bereitsteht. Gerade bei den bereits beschriebenen Maschinen rotierender Bauart ist dies im Sinne kurzer Prozesszeiten und gleichbleibender Beschichtungsqualitäten vorteilhaft.

Bei den gattungsgemäßen Beschichtungsstationen, in denen mehrere Behälter zeitgleich beschichtet werden, müssen diese mehreren Behälter zeitgleich mit Prozessgasen versorgt werden. Es ist die Aufgabe der vorliegenden Erfindung, für dieses Zuführen der Prozessgase eine technisch einfache und zugleich zuverlässige Lösung anzugeben.

Diese Aufgabe wird gelöst mit den Merkmalen des Anspruchs 1. Ausgangspunkt dieser Lösung ist die Überlegung, dass die Zuführung der Prozessgase nach Möglichkeit für alle Behälter zeitgleich und in möglichst identischer Weise erfolgen sollte, um Unterschiede zwischen den Behältern zu vermeiden. Grundsätzlich wäre zwar möglich, solche Unterschiede zu erfassen und dann zu kompensieren, indem für unterschiedliche Behälterplätze auch unterschiedliche Prozessparameter des Beschichtungsvorganges eingestellt würden, z.B. bezüglich Mikrowellenstrahlung oder bezüglich anderer Parameter, die den Beschichtungsvorgang mitbestimmen, wie z.B. Beschichtungsdauern. Dadurch könnte versucht werden, festgestellte Unterschiede in der Prozessgaszufuhr zu kompensieren. Grundsätzlich möglich wäre es auch, die Prozessgaszufuhr zu jedem einzelnen der mehrere Behälter einer Station behälterindividuell zu beeinflussen, z.B. durch Vorsehen von den jeweiligen Behältern zugeordneten einstellbaren Drosseln oder einstellbaren Durchflussmessern, um durch geeignete Einstellung solcher den Zustrom beeinflussender Mittel in allen Behältern gleiche Prozessgasbedingungen herzustellen. Diese genannten Vorgehensweisen werden aber als aufwendig und somit nachteilig angesehen.

Als technisch vorteilhafte und als erfindungsgemäße Lösung wird hingegen eine Beschichtungsstation mit den Merkmalen des Anspruchs 1 vorgeschlagen. Gemäß einem ersten Aspekt wird diese genannte Aufgabe also erfindungsgemäß gelöst durch eine Beschichtungsstation mit den Merkmalen von Anspruch 1. Diese Beschichtungsstation dient der Beschichtung von Behältern in einem auf der Beschichtungsstation ablaufenden Beschichtungsverfahren. Im Besonderen ist die Erfindung anwendungsgeeignet bei der Beschichtung von Innenwänden von Behältern, insbesondere von Flaschen, insbesondere mittels eines PECVD-Verfahrens, insbesondere mittels eines mikrowelleninduzierten PECVD-Verfahrens. Wie auch schon zum Stand der Technik erläutert, weist die Beschichtungsstation eine Beschichtungskammer auf, die in einen geöffneten und einen geschlossenen Zustand überführbar ist und in die die mehreren zu beschichtenden Behälter anordenbar sind zum Zwecke der gleichzeitigen Beschichtung. Öffnen und Schließen der Kammer dienen dem Einführen der mehreren Behälter in die Kammer hinein und der Entnahme der fertigbeschichteten Behälter aus der Kammer heraus. Entsprechende Handhabungseinrichtungen im Sinne von Übergabe- bzw. Entnahmeeinrichtungen sind im Stand der Technik bekannt, z.B. solche, die die mehreren Behälter gleichzeitig handhaben, sodass die mehreren Behälter zeitgleich gehandhabt werden können und nicht zeitlich aufeinanderfolgend gehandhabt werden müssen. Die Kammer ist von Kammerwänden gebildet, die bevorzugt Dichteinrichtungen aufweisen, wobei die Kammer dadurch im geschlossenen Zustand abgedichtet gegen die Außenumgebung verschließbar ausgeführt ist. Aufgrund dieser Abdichtung kann in der Kammer z.B. ein benötigter Unterdruck eingestellt werden, wenn die Kammer mit einer Unterdruckeinrichtung wie z.B. einer Vakuumpumpe verbunden wird. Das Einstellen der Unterdruckbedingungen ist im Stand der Technik bekannt.

In der Kammer sind bevorzugt und in an sich bekannter Art und Weise für das Anordnen der Behälter Halte- und Dichtmittel vorgesehen, die ausgebildet sind, die mehreren Behälter innerhalb der Kammer sowohl gegenüber der Umgebung als auch gegenüber der umgebenden Kammer abgedichtet zu halten. Bevorzugt ist dabei, dass es pro Behälter ein zugeordnetes Halte- und Dichtmittel gibt, die DE 10 2022 119 836 beschreibt z.B. ein solches grundsätzlich geeignetes Halte- und Dichtmittel.

Die Beschichtungsstation weist in grundsätzlich ebenfalls im Stand der Technik bekannter Weise eine Stationsleitung mit einem schaltbaren Stationsventil auf. Eine Steuereinrichtung der Station kann z.B. die Ansteuerung des Ventils übernehmen. Durch diese Stationsleitung soll ventilbeherrscht Prozessgas zum Beschichtungsort geführt werden. Daher ist die Stationsleitung an wenigstens eine Prozessgasquelle anschließbar. Mit der Prozessgasführung hängen auch die Gaslanzen der Beschichtungsstation zusammen, wobei die Beschichtungsstation für jeden der mehreren Behälter eine zugeordnete Gaslanze aufweist, also pro Behälter eine eigene zugeordnete Gaslanze. Jede Gaslanze ragt in einer Beschichtungsstellung in das Behälterinnere hinein und ist in der Beschichtungsstellung über die Stationsleitung mit der Prozessgasquelle verbindbar ausgeführt. Durch die Gaslanze hindurch soll das Prozessgas strömen können und z.B. an der Gaslanzenspitze in das Behälterinnere austreten, gegebenenfalls auch entlang der spitzenseitigen Gaslanzenerstreckung innerhalb des Behälters. Die Gaslanze ist also in aller Regel eine Hohllanze. Es wird deshalb von einer Beschichtungsstellung der Gaslanze gesprochen, weil Gaslanzen häufig in ihrer Längsrichtung beweglich ausgeführt sind, um Behälter nicht auf eine feststehende Gaslanze aufstecken zu müssen, sondern die Gaslanze in den Behälter hineinzubewegen. Die Beschichtungsstellung meint dabei die Stellung der Gaslanze, wenn der Beschichtungsvorgang durchgeführt wird. Soweit eine Gaslanze unbeweglich ausgeführt ist, nimmt die Gaslanze dauerhaft die Beschichtungsstellung ein. Solche Gaslanzen beweglicher und unbeweglicher Art sind im Stand der Technik grundsätzlich bekannt und diese Gaslanzen erfüllen häufig zugleich auch eine Antennenfunktion bzw. sind als Antenne ausgeführt, was vorliegend auch bevorzugt ist.

Innerhalb der Station ist kammerseitig des Stationsventils eine von der Stationsleitung abgehende Zuführleitung für das Prozessgas vorgesehen, die zu den Gaslanzen und damit zu den zugeordneten Behältern verläuft, wobei die Zuführleitung an den Gaslanzen endet und dort ihr Leitungsende hat. Die Zuführleitung spaltet sich dazu auf ihrer Erstreckung zwischen ihrem Anfang und ihrem Ende auf und versorgt gleichzeitig alle Gaslanzen mit Prozessgas. Auch dies ist grundsätzlich im Stand der Technik bekannt.

Die Beschichtungsstation zeichnet sich erfindungsgemäß dadurch aus, dass sich die Zuführleitung verzweigt, nämlich an wenigstens einer Zweigstelle, die zwischen ihrem Leitungsanfang und ihrem Leitungsende angeordnet ist, und sich dort in Teilleitungen aufteilt, wobei jede der Teilleitungen jeweils zu einer der Gaslanzen verläuft. Das Prozessgas strömt also in Kammerrichtung zu einer Zweigstelle und verteilt sich dann auf die davon abzweigenden Teilleitungen. Um über jede dieser Teilleitungen und somit zu jedem Behälter eine gleiche Prozessgasmenge zu führen, sollen erfindungsgemäß Länge und Durchmesser der Zuführleitung und der Teilleitungen so gewählt sein, dass der Strömungswiderstand des Prozessgases ausgehend von dem Stationsventil und durch jede jeweilige Teilleitung hindurch bis zur jeweiligen Gaslanze gleich ist, wobei in den Teilleitungen bevorzugt keine Ventile angeordnet sind. Aufgrund des gleichen Strömungswiderstandes erfolgt eine automatische Gleichverteilung des Prozessgases an den Zweigstellen in die davon abgehenden Abzweigungsleitungen. Die bevorzugte Abwesenheit von Ventilen verringert nicht nur Aufwand und Kosten, sondern ermöglicht die gewünschte Gleichzeitigkeit und vermeidet Gleichverteilungsprobleme. Ventile können sich einerseits unterschiedlich im Strömungswiderstand verhalten und also dem Gleichverteilungsziel zuwiderlaufen. Andererseits können sich die Ventile mit der Zeit auch unterschiedlich zusetzen, was ebenfalls dem Gleichverteilungswunsch zuwiderläuft. Auch unterschiedliche Schaltzeiten könnten nachteilig wirken.

Erfindungsgemäß wird also zunächst über eine Stationsleitung das Prozessgas geführt und nachfolgend zeitgleich auf die mehreren Behälter in der Kammer verteilt, indem sich in der Beschichtungsstation die prozessgasführende Leitung zur Kammer hin an Zweigstellen aufspaltet. Die Gleichverteilung auf die mehreren Behälter gelingt, indem das Prozessgas mit dem gleichen Strömungswiderstand zu jeder Gaslanze geführt wird, um hernach z.B. über einen Plasmaabscheideprozess auf der Innenwand des Behälters abgeschieden zu werden. Dies erfolgt in aller Regel in einer Art Durchlaufverfahren, indem zeitgleich aus dem Behälterinneren über eine Absaugeinrichtung das überschüssige Prozessgas abgesaugt wird, sodass im Behälterinneren weiterhin der erforderliche Unterdruck für das Entstehen eines Plasmas aufrechterhalten bleibt. Die vorliegende Erfindung ermöglicht auf einfache Weise die gleichzeitige Gleichverteilung des über eine zentrale Prozessgasleitung, der Stationsleitung, zugeführten Prozessgases auf die mehreren Behälter.

Die einfachste und somit bevorzugte Realisierung eines gleichen Strömungswiderstandes gelingt, indem alle Teilleitungen die gleiche Länge und den gleichen Durchmesser aufweisen. Die gleiche Länge ist z.B. erreichbar, indem die Anordnung der Zweigstelle und die Anordnung der von der Zweigstelle abgehenden Teilleitungen relativ zu den Gaslanzen bzw. relativ zu den Behältern bestimmte Symmetriebedingungen erfüllen, die beispielhaft später in der Figurenbeschreibung anhand von Ausführungsbeispielen erläutert werden. Eine solche symmetrische Anordnung ist auch in der Herstellung vorteilhaft. Der zweite Aspekt der Erfindung betrifft also in einer Ausprägung die Symmetrie der Anordnung der Zuführleitung und von deren Teilleitungen zu den Gaslanzen. Durch diese Symmetrie bzw. verallgemeinert gesprochen durch das Vorsehen gleicher Strömungswiderstände in den Teilleitungen, gelingt mit Vorteil, dass keine der Gaslanzen gegenüber anderen Gaslanzen strömungstechnisch ausgezeichnet ist.

Eine besonders einfache Realisierung eines gleichen Strömungswiderstandes gelingt dadurch, dass bei Beschichtungsstationen für die gleichzeitige Beschichtung von 2" gleichen Behältern mit n als natürlicher Zahl und n > 1, die entsprechend von 2" jeweils zugeordneten Gaslanzen in ihrem Innenraum mit Prozessgas versorgt werden, die Aufspaltung der Zufuhrleitung nicht nur an einer Zweigstelle 1. Ordnung erfolgt, sondern dass die davon weglaufenden Teilleitungen im weiteren Verlauf und jeweils an Zweigstellen 2. Ordnung weiter in Unterleitungen aufgespalten werden. Die Teilleitungen könnten auch als Zufuhrleitungen 1. Ordnung und die Unterleitungen könnten auch als Zufuhrleitungen 2. Ordnung bezeichnet werden. Auch diese Aufspaltung in mehrfacher Ordnung erweist sich insbesondere dann als besonders einfach realisierbar, wenn die jeweiligen Zufuhrleitungen 1. Ordnung (vorstehend auch Teilleitung genannt) und zweiter Ordnung (vorstehend auch Unterleitung genannt) jeweils untereinander eine gleiche Länge und einen gleichen Durchmesser aufweisen. Alle Zufuhrleitungen 1. Ordnung haben also bevorzugt eine gleiche Länge und einen gleichen Querschnitt, und alle Zufuhrleitungen 2. Ordnung haben ebenfalls untereinander eine gleiche Länge und einen gleichen Querschnitt. Weiter ist bevorzugt, dass an jeder Zweigstelle eine Aufteilung in genau zwei Unterleitungen erfolgt. Entsprechend wären bei 2" Behältern bzw. Gaslanzen Zweigstellen bis zur n. Ordnung vorzusehen. Bei 4 Behältern wären also Zweigstellen 1. und 2. Ordnung vorzusehen, bei 8 Behältern wären z.B. zusätzlich Zweigstellen 3. Ordnung vorzusehen usw.. Das Aufspalten der Leitungen an den Zweigstellen in jeweils zwei Unterleitungen wird generell als vorteilhaft betrachtet gegenüber Alternativen, eine Aufspaltung in mehr als zwei Unterleitungen vorzusehen.

Es kann vorteilhaft sein, dass die Zufuhrleitungen 1., 2. oder höherer Ordnungen jeweils alle untereinander durch Querleitungen verbunden sind. Etwaige noch vorhandene Unterschiede im Leitungsverhalten der Zufuhrleitungen gleicher Ordnung lassen sich dadurch weiter ausgleichen, z.B. in Fällen, in denen diese Unterschiede entstehen, weil sich Leitungen in unterschiedlicher Weise über die Zeit zusetzen.

Beweglich angeordnete Gaslanzen erleichtern das Anordnen von Behältern in der Beschichtungskammer und das Entnehmen der Behälter aus der Kammer. Für diesen Fall beweglicher Gaslanzen ist besonders bevorzugt, dass mehrere Gaslanzen, bevorzugt alle Gaslanzen, an einem gemeinsamen Lanzenschlitten angeordnet sind, und der Lanzenschlitten beweglich, insbesondere höhenbeweglich ausgeführt ist. Ein besonderer Vorteil ergibt sich dadurch, dass in dem Lanzenschlitten zu den davon getragenen Gaslanzen führende Teilleitungen (Zufuhrleitungen 1. Ordnung) oder Unterleitungen (Zufuhrleitungen 2. Ordnung) ausgebildet sind, die in Strömungsverbindung mit der Gaslanze stehen, wobei innerhalb des Lanzenschlittens die Zweigstellen n.-Ordnung angeordnet sind, wobei weiter bevorzugt außerhalb des Lanzenschlittens die Zweigstellen (n-1). Ordnung angeordnet sind. Der Lanzenschlitten dient dann nicht nur der Bewegung der Lanzen, sondern auch der Zuführung des Prozessgases zu den Gaslanzen. Wenn der Lanzenschlitten z.B. blockartig ausgebildet ist, könnten diese prozessgasführenden Leitungen als Bohrungen innerhalb des Blockes ausgeführt sein. Innerhalb des Schlittens erfolgt dabei die Aufspaltung von einer Leitung (n-1). Ordnung in mehrere Leitungen n. Ordnung, z.B. an einer Zweigstelle 2. Ordnung von einer Leitung 1. Ordnung in zwei Leitungen 2 Ordnung. Die Zweigstelle z.B. 1. Ordnung soll dabei bevorzugt nicht im Lanzenschlitten vorgesehen sein, sondern in einem Bereich außerhalb des Lanzenschlittens, z.B. in dem Bereich des später noch angesprochenen Ventilträgerblockes.

In an sich bekannter Weise könnten auf der Beschichtungsstation z.B. während des dort ablaufenden Beschichtungsverfahrens mehrere unterschiedliche Beschichtungen abgeschieden werden. Weiter oben wurden solche mehrschichtigen Beschichtungen bereits angesprochen, beispielsweise bestehend aus einer Haftvermittlerschicht, der eigentlichen Barriereschicht und einer äußeren Schutzschicht. Dazu sind den Gaslanzen unterschiedliche Prozessgase zuführbar, z.B. über mehrere Leitungen, über die die benötigten Prozessgase in der benötigten Zusammensetzung zugeführt werden und beispielsweise beherrscht durch schaltbare Ventile, die von einer Steuereinrichtung in der geeigneten Abfolge geöffnet und geschlossen werden. Anders ausgedrückt ist die Beschichtungsstation mit entsprechenden Leitungen für die Zufuhr unterschiedlicher Prozessgase ausgestattet, indem hierzu die Station für jedes der Prozessgase eine jeweils von einem zugeordneten schaltbaren Prozessgasventil beherrschte Prozessgasleitung aufweist, welche auf der kammerabgewandten Seite des Stationsventils in die Stationsleitung mündet. Bei einer steuerbaren bzw. schaltbaren Ausbildung des Stationsventils und der Prozessgasventile kann z.B. eine damit verbundene Steuereinrichtung durch geeignete Ansteuerung der besagten Ventile den Zustrom des gerade benötigten Prozessgases ermöglichten, während z.B. nicht benötigtes Prozessgas durch Schließen des zugeordneten Prozessgasventils nicht zugeführt wird. Soll gar kein Prozessgas zu den Behältern geführt werden, kann z.B. das Stationsventil in die geschlossene Stellung gesteuert werden.

Es ist auch bekannt, diese mehreren schaltbaren Ventile, nämlich einerseits für die unterschiedlichen Prozessgase, andererseits das Stationsventil, gegebenenfalls ein Bypassventil, an einem sogenannten Ventilträgerblock anzuordnen. Ein solcher Ventilträgerblock zeichnet sich zunächst dadurch aus, dass die Ventile zueinander räumlich benachbart an einem gemeinsamen Trägerkörper angeordnet sind. Dies führt zu einer gewünschten Kompaktheit und dies führt zu Montagevorteilen gegenüber der Anordnung der Ventile ohne einen solchen gemeinsamen Trägerkörper. Der besagte Trägerkörper umfasst einerseits die Möglichkeit, dass die besagten Ventile lediglich in befestigter Weise an dem Körper angeordnet sind. Dies umfasst andererseits auch die Möglichkeit, dass der Trägerkörper selber z.B. in Form von entsprechenden Bohrungen an der Ventilfunktion und/oder an Leitungsfunktionen beteiligt ist. Es wird mit Vorteil vorgeschlagen, dass die mehreren Prozessgasventile gemeinsam an einem solchen Ventilträgerblock angeordnet sind. Zusätzlich vorteilhaft ist, wenn auch das Stationsventil an diesem gleichen Ventilträgerblock angeordnet ist. Es bietet sich insbesondere an, diese Ventile in gestapelter Weise anzuordnen, wobei in diesem Fall insbesondere mit Vorteil vorgeschlagen wird, das Stationsventil der Stationskammer am nächsten liegend anzuordnen. Auf diese Weisen werden kleine Totraumvolumina erreicht, die das schnelle Einstellen der gewünschten Prozessgasbedingungen begünstigen.

Zu den vorgenannten Ausführungsvarianten ist jeweils bevorzugt, dass der Ventilträgerblock ortsfest mit der Beschichtungsstation verbunden ist. Zu den Ventilen führende Leitungen, z.B. elektrische, pneumatische oder andere Leitungen, die für das Funktionieren der Ventile erforderlich sind, müssen auf diese Weise nicht für eine Bewegung des Blockes ausgelegt werden. Dies gilt in gleicher Weise z.B. für die von den Ventilen beherrschten Leitungen. Fehlfunktionen oder Verschleiß aufgrund solcher Bewegungen werden vermieden und es muss auch kein Bauraum für solche Bewegungen bereitgestellt werden.

Bezüglich des oben in unterschiedlichen Ausführungsvarianten beschriebenen Ventilträgerblockes mit daran angeordneten Ventilen ist bevorzugt, dass in dem Ventilträgerblock oben beschriebene Teilleitungen ausgebildet sind und eine oben beschriebene Zweigstelle angeordnet ist, insbesondere die erste Zweigstelle bzw. die Zweigstelle 1. Ordnung und/oder wobei die Stationsleitung wenigstens über eine Teillänge in dem Ventilträgerblock ausgebildet ist. Dies hat den Vorteil, dass der Trägerblock über die reine Funktion als Trägerkörper hinaus bestimmte Leitungsfunktionen und/oder Verteilungsfunktionen übernimmt, z.B. eine Leitungsfunktion durch die zumindest teilweise Ausbildung der Stationsleitung. Die Anordnung einer Zweigstelle innerhalb des Trägerkörpers des Ventilträgerblockes hat zudem den Vorteil, dass die gewünschte Gleichverteilung der Prozessgase ausgehend von der Stationsleitung auf die zu den Gaslanzen führenden Abzweigungsleitungen in kompakter Form bereits im Ventilträgerblock beginnt. Insbesondere in Verbindung mit der weiter oben dargestellten Möglichkeit, im Lanzenschlitten ebenfalls eine solche Verteilungsfunktion vorzusehen, ergibt sich die besonders vorteilhafte Möglichkeit, eine erste Leitungsaufspaltung und Prozessgasaufteilung bereits im Ventilträgerblock vorzusehen und anschließend, bevorzugt unmittelbar anschließend, eine weitere Aufspaltung und Aufteilung innerhalb des Lanzenschlittens vorzusehen. Es ergibt sich eine hohe Kompaktheit und die gewünschte Gleichverteilung der Prozessgase auf kleinem Bauraum. Wenn sich Ventilträgerblock und Lanzenschlitten in der Beschichtungsstellung unmittelbar aneinander anschließen sollen, ist bevorzugt in dieser Beschichtungsstellung ein gasdichter Übergang der Prozessgase dazwischen vorgesehen, z.B. indem in der Beschichtungsstellung die beiden angesprochenen Körper gasdicht aneinanderstoßen, indem z.B. an den Prozessgasübergängen entsprechende Dichtmittel vorgesehen sind, z.B. die Übergangsbereiche umgebende Ringdichtungen. Solche Dichtmittel können einseitig auf einer der zur Anlage gelangenden Flächen angeordnet sein oder auf beiden Flächen. Entsprechende Dichtmittel und Dichtungen sind im Stand der Technik bekannt.

Eine bevorzugte Ausführungsvariante der vorstehend in unterschiedlichen Ausprägungen beschriebenen Ventilträgerblöcke sieht vor, dass an dem Ventilträgerblock in Erstreckungsrichtung der Stationsleitung mehrere Prozessgasventile übereinandergestapelt angeordnet sind und die davon beherrschten Prozessgasleitungen entlang der Erstreckungsrichtung in die Stationsleitung einmünden, wobei weiter bevorzugt auch das Stationsventil an diesem Ventilträgerblock angeordnet ist, wobei in diesem Fall weiter bevorzugt das Stationsventil am der Stationskammer zugewandten Ende der Stationsleitung angeordnet ist. Diese beschriebene Anordnung erweist sich als kompakt, sie vermeidet unnötige Toträume und sie ist strömungstechnisch günstig.

Es war bereits erläutert worden, dass es grundsätzlich für das Einsetzen der Behälter in die Beschichtungskammer hinein und für das Entnehmen der Behälter aus der Beschichtungskammer heraus vorteilhaft ist, wenn dazu die Gaslanzen weggeführt werden. Entsprechend wird mit Vorteil vorgeschlagen, dass der Gaslanzenschlitten in Längsrichtung der Gaslanzen beweglich relativ zum Ventilträgerblock ausgeführt ist. In der Ausführungsvariante, dass sowohl im Gaslanzenschlitten als auch im Ventilträgerblock eine Zweigstelle und Abzweigungsleitungen vorgesehen sind und dazwischen ein Prozessgasübergang erfolgen soll, könnte dies z.B. bedeuten, dass der Gaslanzenschlitten in seiner Beschichtungsstellung, also während des Beschichtungsvorganges, gasdicht am Ventilträgerblock anliegt, im Zustand weggeführter Gaslanzen würde ein solches gasdichtes Anliegen z.B. nicht mehr vorliegen.

Sogenannte Bypassventile und Bypassleitungen sind im Stand der Technik grundsätzlich bekannt. Über solche Bypassleitungen wird z.B. Prozessgas abgeführt, welches z.B. aufgrund eines Behälterwechsels nicht in Behälter zugeführt werden kann. Es soll dadurch vermieden werden, dass in den Prozessgasleitungen die Gasströmung zum Erliegen kommt und insofern wird über diese sogenannten Bypassleitungen auch während des Behälterwechsels für eine weitgehend unterbrechungsfreie Gasströmung gesorgt. Das die Bypassleitung beherrschende Bypassventil ist entsprechend schaltbar ausgeführt und mit einer die geschilderte Funktion ermöglichenden Steuereinrichtung verbunden. Es wird daher mit Vorteil vorgeschlagen, dass die Beschichtungsstation eine von einem Bypassventil beherrschte Bypassleitung aufweist, die in die Stationsleitung mündet und über die die Stationsleitung mit einer Unterdruckquelle verbindbar ist. Im Sinne einer vorteilhaften Kompaktheit wird vorgeschlagen, dass das Bypassventil an dem in mehreren Ausführungsvarianten zuvor beschriebenen Ventilträgerblock angeordnet ist. Damit die Bypassleitung die oben geschilderte Funktion wahrnehmen kann, weist die Beschichtungsstation z.B. eine Steuereinrichtung auf. Diese Steuereinrichtung muss nicht an der Beschichtungsstation angeordnet sein, sondern sie kann auch entfernt von der Beschichtungsstation angeordnet sein. Diese Steuereinrichtung kann z.B. auch noch weitere Beschichtungsstationen steuern und/oder weitere Einrichtungen, z.B. weitere Einrichtungen einer Beschichtungsmaschine, zu der eine oder mehrere der vorstehend beschriebenen Stationen gehört. Das Bypassventil ist unabhängig vom Stationsventil betätigbar, beide können also unabhängig voneinander in einen geöffneten und in einen geschlossenen Zustand gesteuert werden. Nicht ausgeschlossen ist aber, dass beide zeitweise auch den gleichen Zustand aufweisen, wenn dies für eine andere Funktion als die Bypassfunktion gewünscht ist. Die Steuereinrichtung ist für die Bypassfunktion jedenfalls ausgebildet und eingerichtet, das Stationsventil und das Bypassventil im Produktionsbetrieb der Station alternierend zu öffnen und zu schließen, und um bei geöffnetem Bypassventil wenigstens eines der Prozessgasventile wenigstens zeitweise in den geöffneten Zustand zu steuern. Der Produktionsbetrieb der Station umfasst nicht nur den Beschichtungsbetrieb, sprich den Zeitraum, in dem die Beschichtungen auf Behälter abgeschieden werden. Er umfasst insgesamt den Betriebszeitraum, in dem Behälter kontinuierlich der Station zugeführt, darin beschichtet und weggeführt werden. Dieser Produktionsbetrieb ist aber z.B. zu unterscheiden von einem Standby-Betrieb, einem Wartungsbetrieb, einem Hochfahr- oder Herunterfahrbetrieb oder einem Testbetrieb.

Es ist dabei bevorzugt, dass die Bypassleitung weiter entfernt vom Stationsventil als jede der Prozessgasleitungen in die Stationsleitung mündet. Alternativ mündet die Bypassleitung näher am Stationsventil in die Stationsleitung als alle Prozessgasleitungen.

In Bezug auf die schaltbaren Ventile, die vorstehend genannt wurden, können diese z.B. als Magnetventil ausgeführt sein, also bei Strombeaufschlagung der Ventile eine Magnetkraft das Ventil öffnen oder schließen. Gedacht ist auch an pneumatisch oder hydraulisch arbeitende Ventile, die z.B. Pilotventile aufweisen, welche wiederum als Magnetventil ausgeführt sind. Es sind grundsätzlich auch mechanisch schaltende Ventile nicht ausgeschlossen, z.B. kurvengesteuert schaltende mechanische Ventile. Der Begriff des schaltbaren Ventils meint generell, dass eine Steuerung das Ventil aus einer Offen- in eine Geschlossenstellung und umgekehrt überführen kann. Damit ist nicht ausgeschlossen, dass auch Zwischenstellungen eingenommen werden können. Primär geht es aber um das von einer Steuerung ausgelöste Öffnen und Schließen der Ventile. Mit Vorteil handelt es sich bei diesen Ventilen um Magnetventile oder um pneumatische Ventile, wobei diese pneumatischen Ventile z.B. ein magnetisches Pilotventil aufweisen können. Diese bevorzugten Ventile zeichnen sich in Bezug auf Kosten, Schaltgeschwindigkeit und Schaltgenauigkeit aus.

Besonders hohe Produktionsleistungen sind erreichbar mit Maschinen rotierender Bauart. Die vorstehenden Ausführungsvarianten sind also besonders geeignet für solche Maschinen rotierender Bauart. Insofern ist eine bevorzugte Ausführungsform der Erfindung, dass eine Beschichtungsstation, wie zuvor in verschiedenen Varianten beschrieben, weiter bevorzugt mehrere Beschichtungsstationen, auf einem Beschichtungsrad angeordnet ist bzw. sind, das zu einem kontinuierlich drehenden Umlauf antreibbar ausgebildet und gelagert ist. Dies beschreibt ein übliches Arbeitsrad, auf dem während eines kontinuierlichen Umlaufs in einer oder mehreren Arbeitsstationen ein Behandlungsschritt ausgeführt wird. Vorliegend ist dieser Behandlungsschritt eine Beschichtung eines Behälters, das Arbeitsrad ein Beschichtungsrad und die Arbeitsstation eine Beschichtungsstation. Die anspruchsgemäßen Zweigstellen sind dabei in einem mit dem Beschichtungsrad umlaufenden Bereich angeordnet. Bevorzugt sind mehrere solcher Beschichtungsstationen auf dem Beschichtungsrad angeordnet, bevorzugt in äquidistant umfangsverteilter Art.

Weitere Aspekte der Erfindung betreffen also auch solche Beschichtungsräder mit einer oder mehreren Beschichtungsstationen gemäß einer der vorstehend erläuterten diversen Ausführungsvarianten, sowie Beschichtungsmaschinen mit einer oder mehreren solcher Beschichtungsstationen, insbesondere wenn diese auf einem Beschichtungsrad angeordnet sind.

Nachfolgend wird die Erfindung anhand von bevorzugten Ausführungsbeispielen und anhand der beiliegenden Figuren näher erläutert. Die Zeichnungen sind nicht unbedingt maßstabsgetreu, sondern sie sind als Prinzipdarstellungen zu verstehen. In den Figuren sind gleiche oder im Wesentlichen funktionsgleiche bzw. -ähnliche Elemente mit den gleichen Bezugszeichen bezeichnet. Ohne Beschränkung der Allgemeinheit sind Flaschen ein typischer Anwendungsfall eines Behälters. Insofern wird bei der nachfolgenden Beschreibung konkreter Ausführungsbeispiele nur noch von Flaschen gesprochen. Weiterhin wird nachfolgend zur Erläuterung der Erfindung insbesondere und ebenfalls ohne Beschränkung der Allgemeinheit auf Behälter aus einem thermoplastischen Kunststoff eingegangen, insbesondere auf Behälter aus PET, und insbesondere wird eine Innenbeschichtung solcher Behälter beschrieben. Es zeigen:
- Fig. 1: eine schematische Aufsicht auf eine Beschichtungsanlage, wie sie im Grundaufbau und grundsätzlich im Stand der Technik bekannt ist;
- Fig. 2: eine perspektivische Ansicht auf ein erstes Beispiel für eine vereinzelte Beschichtungsstation, wie grundsätzlich im Stand der Technik bekannt;
- Fig. 3: eine Schnittansicht durch ein zweites Beispiel für eine vereinzelte Beschichtungsstation mit Doppelkammer und wie grundsätzlich im Stand der Technik bekannt;
- Fig. 4: eine schematische Darstellung zu einem erfindungsgemäßen Ausführungsbeispiel;
- Fig. 5: eine weitere schematische Darstellung zu einem weiteren erfindungsgemäßen Ausführungsbeispiel;
- Fig. 6: eine vereinfachende Prinzipdarstellung zu einem weiteren erfindungsgemäßen Ausführungsbeispiel.

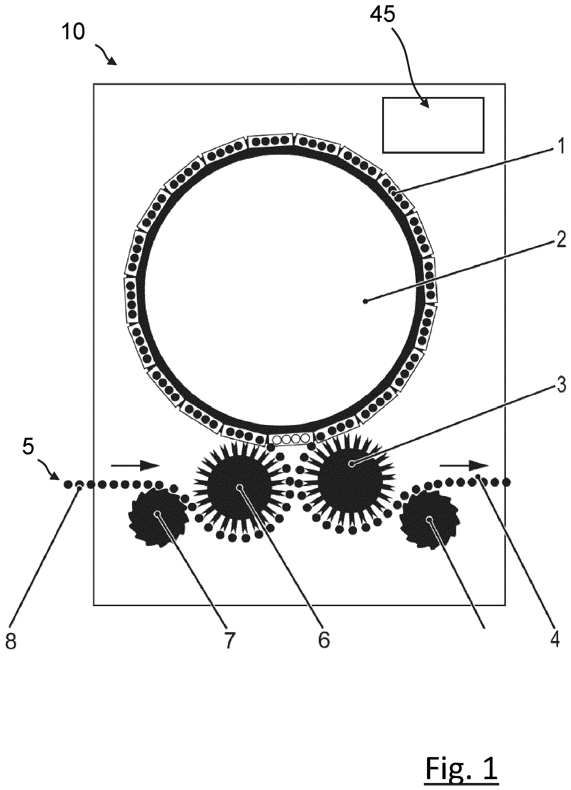

Aus der Darstellung in Fig. 1 ist eine Beschichtungsanlage, genauer gesagt eine PECVD-Anlage 10 zu erkennen, die mit einem rotierenden Beschichtungsrad 2 versehen ist. Entlang eines Umfanges des Beschichtungsrades 2 sind umfangsbeabstandet eine Mehrzahl von Beschichtungsstationen 1 angeordnet. Da plasmabasierte Beschichtungsvorgänge stattfinden, wird nachfolgend auch von einem Plasmarad 2, Plasmastationen 1 und Plasmakammern 17 gesprochen. In synonymer Weise könnte auch von einem Beschichtungsrad 2, von Beschichtungskammern 17 und von Beschichtungsstationen 1 gesprochen werden, da es um Beschichtungsvorgänge geht.

Die Plasmastationen 1 sind mit später noch gezeigten Kavitäten bzw. Plasmakammern 17 zur Aufnahme von zu behandelnden Flaschen 5 versehen. Beispielhaft ist gezeigt, dass jede Plasmastation 1 vier Behandlungsplätze innerhalb jeder Plasmakammer 17 aufweist. Diese PECVD-Anlage 10 steht rein exemplarisch für alle Beschichtungsanlagen, die unter Zuführung von Prozessgasen Beschichtungsprozesse ausführen. Weiterhin werden nachfolgend die Behälter lediglich beispielhaft von Flaschen 5 gebildet.

Die zu behandelnden Flaschen 5 werden dem Plasmarad 2 im Bereich einer Eingabe 8 zugeführt und über ein Vereinzelungsrad 7 an ein Übergaberad 6 weitergeleitet, das mit Tragarmen ausgestattet ist, die z.B. positionierbar ausgeführt sein können. Die Tragarme können z.B. relativ zu einem Sockel des Übergaberades 6 verschwenkbar angeordnet sein, so daß eine Abstandsveränderung der Flaschen 5 relativ zueinander durchgeführt werden kann. Hierdurch erfolgt eine Übergabe der Flaschen 5 vom Übergaberad 6 an das Plasmarad 2. Nach einer Durchführung der Behandlung während des Umlaufes auf dem Plasmarad 2 werden die behandelten Flaschen 5 von einem Ausgaberad 3 aus dem Bereich des Plasmarades 2 entfernt und in den Bereich einer Ausgabestrecke 4 überführt.

Es sind im Stand der Technik die beiden Möglichkeiten bekannt, die z.B. als Flaschen 5 ausgebildeten Werkstücke 5 mit Mündungsbereich nach oben oder nach unten weisend zu beschichten. Da der Transport der Flaschen 5 einfacher ist, wenn der Mündungsbereich nach oben weist, könnte z.B. die Zuführung der Flaschen 5 im Bereich der Eingabe 8 mit Mündungsbereich nach oben weisend erfolgen und z.B. auf dem Übergaberad 6 die Flasche 5 gewendet werden in eine Positionierung mit Mündungsbereich nach unten. Arbeitsräder mit einer solchen Wendefunktion sind im Stand der Technik bekannt. In dieser Positionierung würde die Übergabe der Flasche 5 auf das Plasmarad 2 erfolgen und auch die Entnahme vom Plasmarad 2 nach erfolgter Behandlung. Das Ausgaberad 3 könnte dann erneut ein Wenden der Flasche 5 vornehmen und die Flasche 5 anschließend mit einer Positionierung mit Mündung nach oben der Ausgabestrecke 4 zugeführt werden. Ohne Beschränkung der Allgemeinheit wird in allen nachfolgenden Abbildungen eine Positionierung der Flasche 5 mit Mündungsbereich nach unten weisend gezeigt. Möglich ist natürlich auch, dass die Behandlung auf dem Plasmarad 2 mit Mündungsbereich nach oben weisend erfolgt und kein Wendevorgang vor und nach dem Plasmarad 2 ausgeführt wird. Nicht grundsätzlich ausgeschlossen ist auch eine andere Ausrichtung der Flaschen während der Besch ichtu ngsprozesse.

In nicht dargestellter Weise, weil im Stand der Technik hinreichend bekannt, werden Prozessgase erzeugt, z.B durch Verdampfen flüssiger Precursor, z.B. durch Mischen mit weiteren Gasen. Diese so erzeugten Prozessgase gelangen zum Plasmarad 2 und werden über im Stand der Technik bekannte Drehdurchführungen auf das Plasmarad 2 geführt. Die auf das Plasmarad 2 übergebenen Prozessgase liegen bei der Übergabe in der erforderlichen Zusammensetzung vor und werden von einer außerhalb des Plasmarades 2 angeordneten Gasversorgungsvorrichtung 44 bereitgestellt, die nicht weiter beschrieben wird, da diese für den Gegenstand der Erfindung nicht wesentlich ist. Die Zuführung erfolgt in der Regel in einem Zentrum des Plasmarades 2 und über einen dort angeordneten Drehverteiler, über den die Plasmastationen 1 auch mit Betriebsmitteln sowie Energie versorgt werden. Zur Prozessgas- und zur Betriebsmittelverteilung werden insbesondere Ringleitungen eingesetzt, die den mit dem Plasmarad 2 umlaufenden mehreren Plasmastationen 1 die für den Beschichtungsprozess notwendigen Prozessgase zuführt, z.B. jeweils zu einerzugeordneten Stationsleitung 70.

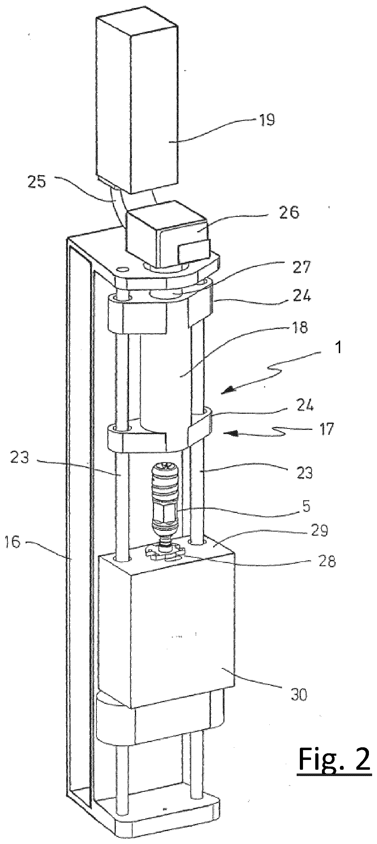

In Fig. 2 ist zur Erläuterung eines möglichen grundsätzlichen Aufbaus einer Plasmastation 1 in perspektivischer Darstellung eine Station mit einem Einzelbehandlungsplatz gezeigtdie Station ist insoweit nicht gattungsgemäß. In grundsätzlicher Hinsicht kann daran gleichwohl gezeigt werden, wie gattungsgemäße Stationen mit mehr als einem Behandlungsplatz ausgeführt sind. Ein Stationsrahmen 16 ist mit Führungsstangen 23 versehen, auf denen ein Schlitten 24 zur Halterung der zylinderförmigen Kammerwandung 18 geführt ist. Fig. 2 zeigt den Schlitten 24 mit Kammerwandung 18 in einem angehobenen Zustand, so daß der auf dem Kopf stehende Behälter in Form einer Flasche 5 freigegeben ist. Im angehobenen Zustand der Kammerwandung 18 befindet sich die Plasmakammer 17 in einer Offenstellung, im abgesenkten Zustand der Kammerwandung 18 befindet sich die Plasmakammer 17 in einer Geschlossenstellung.

Im oberen Bereich der Plasmastation 1 ist ein Mikrowellengenerator 19 angeordnet. Der Mikrowellengenerator 19 ist über eine Umlenkung 25 und einen Adapter 26 an einen Kopplungskanal 27 angeschlossen, der in die Plasmakammer 17 einmündet. Der Adapter 26 hat die Funktion eines Übergangselementes. Die Umlenkung 25 ist als ein Hohlleiter ausgebildet. Die Flasche 5 wird im Bereich eines zangenartigen Halte- und Dichtelementes 28 positioniert, das im Bereich eines Kammerbodens 29 angeordnet ist, und das z.B. wie in der DE 10 2022 119 836 beschrieben ausgeführt sein kann. Der Kammerboden 29 ist als Teil eines Kammersockels 30 ausgebildet.

Zum Schließen der Plasmakammer 17 kann der Schlitten 24 mit der zylinderförmigen Kammerwandung 18 entlang der Schienen 23 abgesenkt werden, bis die Kammerwandung 18 gegen den Kammerboden 29 gefahren ist. In diesem geschlossenen Positionierzustand kann die Plasmabeschichtung der dann in der geschlossenen Kavität 17 eingeschlossenen Flasche 5 durchgeführt werden. Im geschlossenen Positionierzustand erfolgt auch das Einstellen des in der Kammer 17 und des in der Flasche 5 erforderlichen Unterdruckes, um ein Plasma zu erzeugen und mikrowelleninduziert die Plasmabeschichtung vorzunehmen. Im geschlossenen Positionierzustand erfolgt auch ein Belüfteten der Kammer 17 und der in der Kammer 17 aufgenommene Flasche 5 auf einen Umgebungsdruck, damit die Kammer 17 geöffnet werden kann.

In der in Fig. 2 gezeigten angehobenen Positionierung der Kammerwandung 18 ist es ohne Probleme möglich, die behandelte Flasche 5 aus dem Bereich der Plasmastation 1 zu entfernen und eine neue zu behandelnde Flasche 5 einzusetzen, z.B. mittels der in Figur 1 gezeigten Räder 6 und 3.

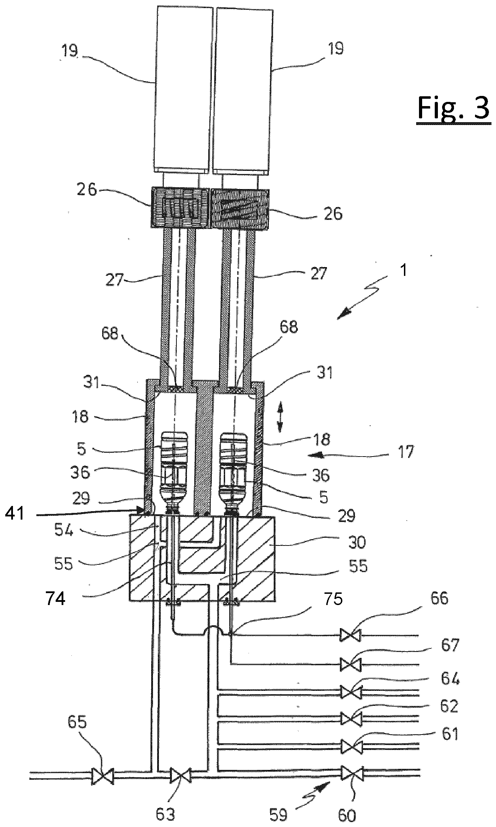

Fig. 3 zeigt ein alternatives Beispiel für eine gattungsgemäße Plasmastation 1 mit einer Plasmakammer 17 zur gleichzeitigen Plasmabehandlung von zwei Flaschen 5. Dazu ist die Kammer 17 in zwei Teilkammern 17a, 17b unterteilt. Alternativ könnte die Unterteilung durch eine Trennwand auch fehlen. Jede der Teilkammern 17a, 17b ist über einen Kopplungskanal 27 sowie einen Adapter 26 und eine Umlenkung 25 an jeweils einen Mikrowellengenerator 19 angeschlossen. Grundsätzlich ist es ebenfalls denkbar, für zwei oder mehr Teilkammern 17a, 17b einen gemeinsamen Mikrowellengenerator 19 zu verwenden und über eine nicht dargestellte Verzweigung eine Aufteilung der generierten Mikrowellenstrahlung vorzunehmen, um eine gleichmäßige Zündung des Plasmas in jeder der Teilkammern 17a, 17b zu gewährleisten.

In die Teilkammern 17a, 17b münden Versorgungskanäle 54 für das Einstellen des Kammerdruckes ein, die jeweils an eine Verzweigung 55 zur Aufteilung der von Pumpen bereitgestellten Saugleistung angeschlossen sind. Bei einer Verwendung von mehr als zwei Plasmakammern 17 wird die Verzweigung 55 entweder mit einer entsprechenden Anzahl von Ausgängen versehen, oder es werden kaskadiert mehrere Teilverzweigungen hintereinander angeordnet. Über diese Kanäle 54, 55 kann z.B. Unterdruck zugeführt werden.

Die Versorgung der beiden Flaschen 5 mit Prozessgasen erfolgt über Gasleitungen 74, die im gezeigten Ausführungsbeispiel an einer Zweigstelle 75 aus einer zentralen Leitung aufgespalten worden sind. In späteren Figuren ist dargestellt, wie demgegenüber die Versorgung mit Prozessgasen erfindungsgemäß ausgeführt ist.

Zusätzlich eingezeichnet ist pro Behandlungsplatz eine Gaslanze 36, die in vertikaler Richtung in die Flasche 5 hineingefahren und herausgeführt werden kann, z.B. in nicht dargestellter Weise durch Anordnung an einem Lanzenschlitten, der in vertikaler Richtung geführt und z.B. kurvengesteuert eine Vertikalbewegung ausführen kann. In der dargestellten Positionierung ist die Plasmakammer 17 geschlossen und die Lanze 36 innerhalb der Flasche 5 angeordnet für das Austragen der Prozessgase in den Innenraum des Behälters 5. Die Gaslanzen 36 nehmen die Beschichtungsstellung ein.

Im Bereich des Kammersockels 30 erfolgt über die schon angesprochenen Kanäle 54, 55 die Beaufschlagung der Plasmakammern 17 und der Behälter 5 mit Unterdruck, auch ein Belüften ist möglich. Prozessgase werden über eine Prozessgasleitung 66 und die sich hinter der Zweigstelle 75 anschließenden Leitungen 74 den Gaslanzen 36 zugeführt und in das Behälterinnere geleitet. Die Zuführung erfolgt jeweils ventilgesteuert. Die Prozessgasleitung 66 steht in Verbindung mit einer nicht dargestellten Gasversorgungsvorrichtung 44 und führt die von dieser Gasversorgungsvorrichtung 44 bereitgestellten Prozessgase zu den Gaslanzen 36.

Fig. 3 zeigt in einer stark schematisierten Darstellung sowie mit zusätzlicher Darstellung von schaltbaren Ventilen 59 die Steuerung und Einstellung der Druckbedingungen und der Prozessgaszufuhr. Sowohl das Prozessgas als auch der Unterdruck werden ausgehend von einer Zufuhrleitung an Zweigstellen auf mehrere Unterleitungen verteilt. Zu erkennen sind ebenfalls Quarzglasfenster 68 zur Abdichtung der Innenräume der Plasmakammern 17 relativ zu den Innenräumen der Kopplungskanäle 27 bei gleichzeitiger Durchtrittsmöglichkeit für die Mikrowellenstrahlung.

Gemäß der gezeigten, rein beispielhaften Ausführungsform werden ein Primärvakuumventil 60 zur Zuführung einer ersten Unterdruckstufe sowie ein Sekundärvakuumventil 61 zur Zuführung eines gegenüber der ersten Unterdruckstufe niedrigeren Unterdruckes verwendet. Das Hinzutreten weiterer Unterdruckstufen ist möglich. Zur Aufrechterhaltung des Vakuums synchron zur Zuführung des Prozessgases ist darüber hinaus ein Prozessvakuumventil 62 angeordnet. Das Prozessvakuumventil 62 vermeidet einen Übertritt von abgesaugtem Prozessgas in die Versorgungskreise für das Primärvakuum und das Sekundärvakuum.

Zur Unterstützung einer wahlweisen oder gemeinsamen Zuführung von Unterdruck zum Innenraum der Flasche 5 und/oder in den weiteren Innenraum der Plasmakammer 17 ist ein Kammervakuumventil 63 verwendet, das eine entsprechende Absperrfunktion durchführt. Insbesondere ist daran gedacht, das jeweilige Versorgungsvakuum über die Ventile 60, 61, 62 jeweils unmittelbar dem Innenraum der Flasche 5 zuzuführen und über das Kammervakuumventil 63 gesteuert eine bedarfsabhängige Zuschaltung des weiteren Innenraumes der Plasmakammer 17 vorzunehmen.

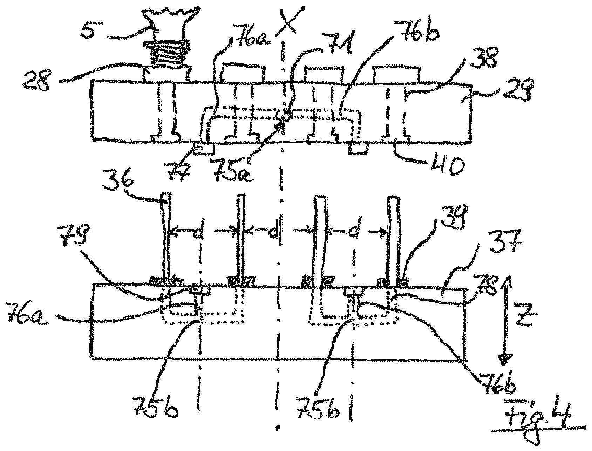

Für eine vorgebbare und voneinander unabhängige Entlüftung sowohl des Innenraumes der Flasche 5 als auch des weiteren Innenraumes der Plasmakammer 17 wird ein Behälterentlüftungsventil 64 sowie ein Kammerentlüftungsventil 65 verwendet. Für eine Zuführung unterschiedlicher Prozessgaszusammensetzungen wird ein erstes Prozessgasventil 66 sowie ein zweites Prozessgasventil 67 verwendet. Denkbar ist auch das Zuführen weiterer Prozessgasmischungen, sodass weitere Leitungen und weitere Ventile hinzutreten könnten. Die Bereitstellung der Prozessgasmischungen erfolgt durch eine Gasversorgungsvorrichtung 44. Erfindungsgemäße Ausbildungen der an der Prozessgaszuführung beteiligten Leitungen werden in den Figuren 4-6 gezeigt.

Nachfolgend wird ein typischer Ablauf eines Beschichtungsverfahrens auf einer Beschichtungsstation erläutert. Bei der Erläuterung wird auf eine Flasche Bezug genommen, also der Ablauf in der Einzahl geschildert. Bei gleichzeitiger Behandlung mehrerer Flaschen laufen die geschilderten Vorgänge gleichzeitig für alle Flaschen ab.

Ein typischer Behandlungsvorgang wird z.B. derart durchgeführt, daß zunächst die Flasche 5 wie zu Figur 1 erläutert zum Plasmarad 2 transportiert wird und das Einsetzen der Flasche 5 in die Plasmastation 1 in einem hochgeschobenen Zustand der hülsenartigen Kammerwandung 18 erfolgt. Nach einem Abschluss des Einsetzvorganges wird die Kammerwandung 18 in ihre abgedichtete Positionierung abgesenkt. Zum Zwecke der Abdichtung weist die Kammerwandung 18 stirnseitig umlaufende Dichtringe als Dichteinrichtung 41 auf. Zunächst wird gleichzeitig eine Evakuierung sowohl der Kavität 17 als auch eines Innenraumes der Flasche 5 durchgeführt, ggf. erfolgt zunächst auch nur eine Vorevakuierung der Kavität 17, bevor auch die Evakuierung des Innenraums der Flasche 5 zugeschaltet wird.

Nach einer ausreichenden Evakuierung des Innenraumes der Kavität 17 wird die Gaslanze 36 in den Innenraum der Flasche 5 eingefahren und eine Abschottung des Innenraumes der Flasche 5 gegenüber dem Innenraum der Kavität 17 durchgeführt. Ebenfalls ist es möglich, die Gaslanze 36 bereits synchron zur beginnenden Evakuierung des Innenraumes der Kavität 17 in die Flasche 5 hineinzuverfahren. Der Druck im Innenraum der Flasche 5 wird anschließend noch weiter abgesenkt. Darüber hinaus ist auch daran gedacht, die Positionierbewegung der Gaslanze 36 wenigstens teilweise bereits parallel zur Positionierung der Kammerwandung 18 durchzuführen. Nach Erreichen eines ausreichend tiefen Unterdruckes wird Prozessgas in den Innenraum der Flasche 5 eingeleitet und mit Hilfe des Mikrowellengenerators 19 das Plasma gezündet. Insbesondere ist daran gedacht, mit Hilfe des Plasmas sowohl einen Haftvermittler auf eine innere Oberfläche der Flasche 5 als auch die eigentliche Barriereschicht z.B. aus Siliziumoxiden abzuscheiden. Eine zusätzliche dritte Schicht, zum Beispiel eine Schutzschicht, könnte ebenfalls mit Hilfe des Plasmas abgeschieden werden, z.B. ebenfalls aus Siliziumoxiden.

Nach einem Abschluss des Beschichtungsvorganges wird die Gaslanze 36 wieder aus dem Innenraum der Flasche 5 entfernt und die Plasmakammer 17 sowie der Innenraum der Flasche 5 werden belüftet. Nach Erreichen des Umgebungsdruckes innerhalb der Kavität der Plasmakammer 17 wird die Kammerwandung 18 wieder angehoben, um eine Entnahme der beschichteten Flasche 5 sowie eine Eingabe einer neuen zu beschichtenden Flasche 5 durchzuführen. Das geschilderte Beschichtungsverfahren läuft ab, während die Flasche 5 in der Plasmastation 1 auf dem Plasmarad 2 umläuft.

Eine Positionierung der Kammerwandung 18 und/oder der Gaslanze 36 kann unter Verwendung unterschiedlicher Antriebsaggregate erfolgen. Grundsätzlich ist die Verwendung pneumatischer Antriebe und/oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades 2 eine Kurvensteuerung zu realisieren. Die Kurvensteuerung kann beispielsweise derart ausgeführt sein, daß entlang eines Umfanges des Plasmarades Steuerkurven angeordnet sind, entlang derer Kurvenrollen geführt werden. Die Kurvenrollen sind mit den jeweils zu positionierenden Bauelementen gekoppelt.

Die Betätigung der Ventile 59 erfolgt vorzugsweise über eine programmierbare elektronische Steuerung 45. Zunächst wird nach einem Schließen der Plasmakammer 17 das Primärvakuumventil 60 geöffnet und der Innenraum der Flasche 5 und der Innenraum der Plasmakammer 17 gleichzeitig oder teilweise zeitlich versetzt evakuiert. Hierbei wird ein Druckniveau z.B. im Bereich von 20 mbar bis 50 mbar erreicht. Nach einem Schließen des Primärvakuumventils 60 erfolgt ein Öffnen des Sekundärvakuumventils 61 und der Innenraum der Flasche 5 und der Innenraum der Plasmakammer 17 werden zunächst gleichzeitig an eine Unterdruckquelle mit einem niedrigeren Druckniveau angeschlossen. Nach einer ausreichenden Evakuierung des die Flasche 5 umgebenden Innenraumes der Plasmakammer 17 schließt das Kammervakuumventil 63 und lediglich der Innenraum der Flasche 5 wird weiter evakuiert. Hierbei wird z.B. ein Druckniveau von etwa 0,1 mbar erreicht.

Nach einem Schließen des Kammervakuumventils 63 und einer in der Regel bereits zuvor erfolgten Positionierung der Gaslanze 36 innerhalb des Innenraumes der Flasche 5 öffnet das erste Prozessgasventil 66, auch Primärprozessgasventil genannt, und ein Prozessgas einer ersten Zusammensetzung wird zugeführt. Nach einer ausreichenden Prozessgaszuführung zündet der Mikrowellengenerator 19 das Plasma im Innenraum der Flasche 5. Zu einem vorgebbaren Zeitpunkt schließt das Primärprozessgasventil 66 und das Sekundärprozessgasventil 67 öffnet zur Zuführung eines Prozessgases einer zweiten Zusammensetzung. Zumindest zeitweise parallel zum Öffnen der Prozessgasventile 66, 67 öffnet auch das Prozessvakuumventil 62, um einen ausreichend niedrigen Unterdruck im Innenraum der Flasche 5 aufrecht zu erhalten. Hierbei erweist sich ein Druckniveau von z.B. etwa 0,3 mbar als zweckmäßig

Nach einem Abschluss der Plasmabeschichtung öffnet zunächst das Behälterentlüftungsventil 64 und schließt den Innenraum der Flasche 5 an einen Umgebungsdruck an. Mit einer vorgebbaren zeitlichen Verzögerung nach einem Öffnen des Behälterentlüftungsventils 64 öffnet auch das Kammerentlüftungsventil 65, um den Innenraum der Plasmakammer 17 wieder vollständig auf den Umgebungsdruck anzuheben. Nach einem zumindest annäherungsweisen Erreichen des Umgebungsdruckes innerhalb der Plasmakammer 17 kann die Plasmakammer 17 öffnen und die beschichtete Flasche 5 wird entnommen und durch eine neue zu beschichtenden Flasche 5 ersetzt.

Die vorstehend beschriebenen Prozessabläufe finden in einer gattungsgemäßen Plasmakammer mit mehreren Behälterbehandlungsplätzen gleichzeitig für jeden der Behandlungsplätze und also simultan für jeden Behälter 5 statt, der auf einem der mehreren Behandlungsplätze angeordnet ist.

Anhand der nachfolgenden Figuren 4-6 sollen Ausführungsbeispiele gezeigt und erklärt werden, wie in erfindungsgemäßer und bevorzugter Weise die gleichzeitige und gleichartige Zuführung der Prozessgase in die Behälter 5 hinein erfolgt. Dabei zeigt Figur 4 eine schematische Darstellung zu einem ersten erfindungsgemäßen Ausführungsbeispiel. Dargestellt sind dabei lediglich diejenigen Elemente einer Beschichtungsstation 1, die für die Zuführung der Prozessgase bedeutsam sind. In Figur 4 sind z.B. diejenigen Stationselemente nicht gezeigt, die z.B. die Beschichtungskammer 17 ausbilden, der Unterdruckerzeugung dienen oder für die Zündung des Plasmas erforderlich sind. Dargestellt sind lediglich in der oberen Bildhälfte der Figur 4 der Kammerboden 29 einer Beschichtungsstation 1 mit vier auf der Oberseite angedeuteten Halte- und Dichtelementen 28 für das abgedichtete Halten von vier Flaschen 5. Es sollen also im gezeigten Beispiel zeitgleich vier Flaschen 5 beschichtet werden. Lediglich exemplarisch ist der Mündungsbereich einer Flasche 5 zu dem am linken Bildrand gezeigten Halte- und Dichtelement 28 dargestellt, während die drei übrigen Flaschen 5 vollständig weggelassen sind.

Im dargestellten Beispiel soll der Kammerboden 29 unbeweglich z.B. auf einem Beschichtungsrad 2 angeordnet sein, d. h. auf und mit dem Beschichtungsrad 2 umlaufen, aber gegenüber dem Rad 2 nicht bewegt werden. In der unteren Bildhälfte der Figur 4 ist ein Lanzenschlitten 37 dargestellt, der entlang des Pfeiles Z relativ zum Kammerboden 29 verschoben werden kann. Diese Verschiebung kann - wie weiter oben ausgeführt - beispielsweise durch eine Kurvensteuerung realisiert sein; weitere mögliche Alternativen sind oben ebenfalls genannt worden. Der Lanzenschlitten 37 trägt auf seiner Oberseite vier Gaslanzen 36, die jeweils gleichbeabstandet mit einem Abstand d voneinander entfernt angeordnet sind. Der gleichbleibende Gaslanzenabstand d findet sich analog und entsprechend im Abstand der Halte- und Dichtelemente 28 auf der Oberseite des Kammerbodens 29 wieder, die also ebenfalls gleichbeabstandet angeordnet sind in einem nicht angegebenen, dem Abstand d angepassten Abstand. Im Kammerboden 29 sind über dessen gesamte Höhenerstreckung mit den Gaslanzen 36 fluchtende Durchlassöffnungen 38 vorgesehen, sodass die Gaslanzen 36 durch den Kammerboden 29 hindurchragend bis in den Innenraum der Flaschen 5 geführt werden können. In dieser angehobenen Position, die der Beschichtungsstellung entspricht, also der Stellung, in der Prozessgas in die Flaschen 5 geführt wird und Beschichtungen abgeschieden werden, gelangen die Lanzendichtungen 39 in dichtende Anlage in eine entsprechende Dichtgegenstruktur 40 auf der Unterseite des Kammerbodens 29.

Die Zuführung der Prozessgase zu den Gaslanzen 36 erfolgt über eine in Figur 4 nicht im Detail gezeigte Stationsleitung 70, die von der blickabgewandten Seite in den Kammerboden 29 hineinläuft und sich dort als Stationsbohrung 71 fortsetzt. Diese insoweit noch zur Stationsleitung 70 gehörende Stationsbohrung 71 teilt sich an einer Zweigstelle 1. Ordnung 75a in zwei Unterleitungen 1. Ordnung 76a und 76b auf. Diese Unterleitungen 1. Ordnung 76a, 76b münden an der Unterseite des Kammerbodens 29 und sind dort von Dichtungen 77 umgeben. Diesen Dichtungen 77 auf der Unterseite des Kammerbodens 29 sind auf der Oberseite des Lanzenschlittens 37 formangepasste und fluchtende Gegenstrukturen zugeordnet, die so ausgeführt sind, dass in der Beschichtungsstellung des Lanzenschlittens 37 ein gasdichter Übergang von den Unterleitungen 1. Ordnung 76a, 76b im Kammerboden 29 zu den Unterleitungen 76a, 76b im Lanzenschlitten 37 erfolgen kann. Die Unterleitungen 1. Ordnung 76a und 76b setzen sich somit im Lanzenschlitten 37 fort und sind insoweit zweigeteilt ausgeführt.

Innerhalb des Lanzenschlittens 37 verlaufen die Unterleitungen 1. Ordnung 76a, 76b jeweils zu Zweigstellen 2. Ordnung 75b, in denen sich jede der Unterleitungen 76a, 76b jeweils aufspaltet in zwei Abzweigungsleitungen 78, die auch als Unterleitungen 2. Ordnung bezeichnet werden können, wobei jede der insgesamt vier entstehenden Abzweigungsleitungen 78 jeweils zu einer der vier Gaslanzen 36 verläuft und daran gasdicht angeschlossen ist. Im Ergebnis erfolgt also eine kaskadierte Aufteilung des Prozessgases an der Zweigstelle 1. Ordnung 75a und den Zweigstellen 2. Ordnung 75b, wobei verallgemeinerungsfähig bevorzugt und gemäß dem gezeigten Beispiel an jeder Zweigstelle die jeweils dort einmündende Leitung in zwei Teilleitungen aufgespalten wird und also das Prozessgas auf zwei nachgeschaltete Leitungen aufgeteilt wird. Im dargestellten Beispiel liegen vier Behandlungsplätze mit vier Behältern 5 und vier Gaslanzen 36 vor, also 2" (mit n=2) Behandlungsplätze, und daher werden bevorzugt n=2 kaskadierende Zweigstellen 1. und (n=2). Ordnung vorgesehen. Dieses Ausführungsbeispiel angewendet auf z.B. acht Behandlungsplätze, mit 8=2" und n=3, wäre also bevorzugt entlang des erklärten Beispiels so fortzuführen, dass hinter den gezeigten Zweigstellen 2. Ordnung 75b in Gaslanzenrichtung Zweigstellen n. Ordnung mit n=3 anzuordnen wären, nämlich vier davon, sodass die vier von den Zweigstellen 2. Ordnung 75b wegführenden Abzweigungsleitungen 78 nochmals jeweils zweigeteilt würden auf dann insgesamt acht Teilleitungen 3. Ordnung.

Besondere Erwähnung verdienen die verallgemeinerungsfähigen und für alle Ausführungsbeispiele bevorzugten Symmetrieverhältnisse, die in Figur 4 dargestellt sind. Eingezeichnet ist eine Symmetrieachse X. Die Gaslanzen 36, die Halte- und Dichtelemente 28 sowie alle Zweigstellen 1., 2. und gegebenenfalls höherer Ordnung sowie alle davon abgehenden prozessgasführenden Leitungen sind symmetrisch zu dieser Achse X bzw. zu einer dieser Achse X enthaltenden Spiegelebene zu beiden Seiten der Achsen verteilt. Dies bedeutet z.B., dass die Gaslanze 36 ganz links am Lanzenschlitten 37 von der Achse X den gleichen Abstand hat, wie die Gaslanze 36 ganz rechts in Figur 4. Entsprechend haben die beiden dazwischenliegenden Gaslanzen 36 jeweils den gleichen Abstand von der Achse X und können durch geeignete Wahl einer Spiegelebene, in der die Achse X verläuft, durch Spiegelung ineinander überführt werden. Dieses Symmetrieprinzip gilt primär und in besonderer Weise für die Zweigstellen 1., 2. und ggf. höherer Ordnung sowie für alle Prozessgasleitungen, die von diesen Zweigstellen ausgehen, d. h. gerade diese genannten prozessgasführenden Leitungen und Zweigstellen können durch Spiegelung an einer Spiegelebene ineinander überführt werden, wobei diese Spiegelebene die Achse X enthält, die im gezeigten Ausführungsbeispiel parallel zur Bewegungsrichtung Z des Lanzenschlittens 37 liegt, im Übrigen vorliegend auch parallel zur Erstreckung der Gaslanzen 36 steht. Aus dieser bevorzugten Symmetrie ergibt sich unter anderem, dass die Leitungslängen und Leitungsdurchmesser aller Leitungen gleicher Ordnung identisch sind, also ergeben sich daraus identische Strömungswiderstände. Es liegen also z.B. zu den beiden Unterleitungen 1. Ordnung 76a, 76b jeweils eine gleiche Leitungslänge und ein gleicher Leitungsquerschnitt vor. Analog liegen zu den Abzweigungsleitungen 78, von denen es in Figur 4 vier gibt, jeweils untereinander gleiche Leitungslängen und gleiche Leitungsquerschnitte vor. Die verlangte Gleichheit in Länge und Querschnitt gilt für die Abzweigungsleitungen untereinander und für die Teilleitungen 1. Ordnung untereinander. Leitungen unterschiedlicher Ordnung können, müssen aber nicht die gleiche Länge und den gleichen Querschnitt aufweisen. Es kann sogar vorteilhaft sein, wenn diese Querschnitte nicht identisch sind, sondern die Querschnitte der Leitungen höherer Ordnung kleiner sind als die Querschnitte der Leitungen niedriger Ordnung, also z.B. die Leitungen 1. Ordnung einen größeren Durchmesser aufweisen als die Leitungen 2. Ordnung.

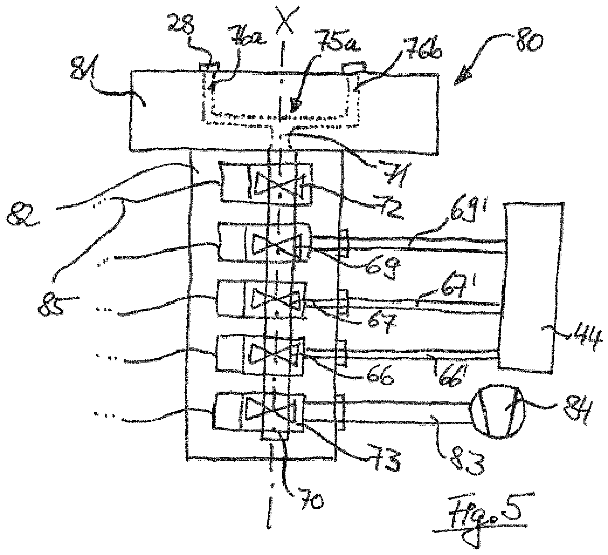

Fig. 5 zeigt eine weitere schematische Darstellung zu einem weiteren erfindungsgemäßen Ausführungsbeispiel, wobei ausschließlich die für die Prozessgasverteilung relevanten Elemente gezeigt sind und wobei die an der Prozessgasverteilung beteiligten Ventile 66, 67, 69, 72, 73 an einem gemeinsamen Ventilträgerblock 80 angeordnet sind. In diesem gezeigten Ausführungsbeispiel sollen zeitgleich zwei nicht gezeigte Flaschen 5 in einer nicht gezeigten Stationskammer 17 mit einer Beschichtung versehen werden. Der Ventilträgerblock 80 weist entsprechend auf seiner Oberseite zwei Halte-und Dichtelemente 28 auf. Der Block 80 bildet somit zugleich den Kammerboden 29 bzw. den Kammersockel 30 aus, der in Figur 3 gezeigt war. Der Kammerboden 29 soll gegenüber der Station 1 unbeweglich sein, sodass in diesem Fall die Flaschen 5 auf die nicht gezeigten Gaslanzen 36 aufgesteckt werden müssen, was zwar als nachteilig angesehen wird, aber von der Erfindung nicht ausgeschlossen ist. Entsprechend weist dieses Ausführungsbeispiel keinen beweglichen Gaslanzenschlitten 37 auf, wie noch zu Figur 4 gezeigt.

Der Ventilträgerblock 80 ist zweigeteilt aufgebaut und besteht aus dem oberen Verteilersockel 81 und dem darunter angeordneten Ventilträgerkörper 82. Beide sind fest miteinander verbunden, könnten aber z.B. auch einstückig ausgebildet sein. Von der Erfindung nicht ausgeschlossen ist auch, dass der Verteilersockel 81 von dem Ventilträgerkörper 82 wegbewegt werden kann, wobei er dann in Aufbau und Funktion dem Lanzenschlitten 37 der Figur 4 ähneln würde.

An dem Ventilträgerkörper 82 sind in einer bevorzugten Variante das Stationsventil 72, die Prozessgasventile 66, 67 und 69 sowie ein sogenanntes Bypassventil 73 angeordnet, wobei das Bypassventil 73 über eine Bypassleitung 83 mit einer Vakuumpumpe 84 verbunden ist. Die jeweiligen Prozessgasventile 66, 67, 69 stehen über zugeordnete Prozessgasleitungen 66', 67', 69' mit der Gasversorgungsvorrichtung 44 in Verbindung. Alle dargestellten Ventile sind im Bereich und entlang der Stationsleitung 70 angeordnet. Das Stationsventil 72 ist im gezeigten Ausführungsbeispiel der Stationskammer 17 nächstbenachbart angeordnet, vorliegend an dem der Stationskammer 17 zugewandten Ende der Stationsleitung 70. Dieses Stationsventil 72 kann in gesteuerter Weise über eine angedeutete Steuerleitung 85 von einer Steuereinrichtung, z.B. von der Steuereinrichtung 45 in Figur 1, in einen geöffneten und in einen geschlossenen Zustand überführt werden. Im geöffneten Zustand wird eine Verbindung zwischen der Stationsleitung 70 und den mehreren Flaschen 5 freigegeben. Im geschlossenen Zustand ist diese Verbindung verschlossen. Die Prozessgasventile 66, 67, 69 sind ebenfalls schaltbar ausgeführt und können über ebenfalls angedeutete Steuerleitungen von einer Steuereinrichtung in einen geschlossenen und in einen geöffneten Zustand überführt werden. Diese Prozessgasventile 66, 67, 69 beherrschen den Zustrom von Prozessgasen aus den Ventilen jeweils zugeordneten Prozessgasleitungen 66', 67', 69' in die Stationsleitung 70 hinein. Sind diese Prozessgasventile 66, 67, 69 geschlossen, so strömt kein Gas durch die zugeordneten Prozessgasleitungen 66', 67', 69' in die Stationsleitung 70 hinein. Sind diese Prozessgasventile 66, 67, 69 geöffnet, so kann Prozessgas aus den zugeordneten Prozessgasleitungen 66', 67', 69' in die Stationsleitung 70 hineinströmen.

Im gezeigten Ausführungsbeispiel sollen die drei gezeigten Prozessgasventile 66, 67, 69 drei unterschiedliche Prozessgasleitungen 66', 67', 69' beherrschen, über die unterschiedliche Prozessgasmischungen zugeführt werden, die von der Gasversorgungsvorrichtung 44 bereitgestellt werden, z.B. wie im Stand der Technik bekannt. Während des Ablaufs eines Beschichtungsverfahrens wird z.B. zunächst das Prozessgasventil 66 geöffnet und ein erstes Prozessgas gelangt in die Stationsleitung 70. Das Bypassventil 73 soll geschlossen sein und das Stationsventil 72 soll sich öffnen, sodass dieses erste Prozessgas in die Flaschen 5 hineinströmen und dort eine erste Beschichtung aufgebracht werden kann. Zur Ausbildung einer zweiten Schicht wird das Prozessgasventil 66 geschlossen und das Prozessgasventil 67 geöffnet, sodass ein zweites Prozessgas, das sich vom ersten Prozessgas unterscheidet, in die Flaschen geführt werden kann, um dort eine zweite Schicht abzuscheiden, z.B. eine Barriereschicht, während es sich bei der ersten Schicht z.B. um eine Haftvermittlerschicht handelt. In einem nächsten Schritt wird das Prozessgasventil 67 geschlossen und das Prozessgasventil 69 geöffnet, um ein drittes Prozessgas durch das weiterhin geöffnete Stationsventil 72 in die Flaschen 5 zu führen und dort eine dritte Schicht abzuscheiden, z.B. eine Schutzschicht. Mit dem Abscheiden der dritten Schicht soll der Beschichtungsvorgang abgeschlossen sein. Das Prozessgasventil 69 wird geschlossen und das Stationsventil 72 wird ebenfalls geschlossen. Nach Ausführung eines Druckausgleichs in Kammer 17 und Flasche 5 kann nachfolgend die Kammer 17 geöffnet und der beschichtete Behälter 5 entfernt werden. Es kann währenddessen kein Prozessgas in die Flaschen 5 geführt werden. Insofern öffnet mit Vorteil währenddessen das Bypassventil 73 und führt das Prozessgas ab, das nicht mehr in Flaschen 5 geführt werden kann.

Im gezeigten Beispiel setzt die Bypassleitung 83 an der Stationsleitung 70 an, sodass für das Wegführen der Prozessgase die Prozessgasventile 66, 67, 69 abwechselnd oder auch gleichzeitig geöffnet werden müssten, um das Prozessgas über die Stationsleitung 70 und die Bypassleitung 83 abführen zu können. In nicht dargestellter Weise wäre es auch möglich, die Bypassleitung 83 jeweils direkt und einzeln und ventilbeherrscht durch nicht dargestellte Ventile mit den Prozessgasleitungen 66', 67', 69' zu verbinden, um in den Phasen, in denen die Prozessgasventile 66, 67, 69 geschlossen sind und kein Prozessgas zu den Flaschen 5 geführt wird, eine offene Verbindung zu der Bypassleitung 83 herzustellen, ohne dass dafür der Weg über die Stationsleitung 70 genommen werden muss.

Die dargestellten Ventile 66, 67, 69, 72, 73 sollen schaltbare Ventile sein. Denkbar ist z.B., alle gezeigten Ventile als Magnetventile auszuführen. Denkbar ist auch, alle als pneumatisch betätige Ventile auszuführen, z.B. mit einem vorgeschalteten Magnetventil als Pilotventil. Möglich ist auch, dass einige der Ventile Magnetventile sind, andere aber pneumatische Ventile. Weitere, weniger bevorzugte Ventilarten sind möglich, z.B. hydraulische Ventile oder mechanisch betätigte Ventile.

Die innerhalb des Ventilträgerkörpers 82 ausgebildete Stationsleitung 70 erstreckt sich in Richtung der Achse X. Entlang dieser Erstreckung sind die oben beschriebenen Ventile 66, 67, 69, 72, 73 in gestapelter Weise angeordnet. Dabei ist wie bereits erklärt bevorzugt, dass das Stationsventil 72 am stationskammerseitigen Ende der Stationsleitung 72 angeordnet ist, also näher an der Stationskammer 17 als alle anderen Ventile, insbesondere näher als das Bypassventil 73 und/oder als alle Prozessgasventile 66, 67, 69. Dadurch werden Totraumvolumina klein gehalten. Im gezeigten Beispiel ist das Bypassventil 73 am weitesten entfernt vom Stationsventil 72 angeordnet, es kann aber auch vorteilhaft sein, das Bypassventil 73 unmittelbar benachbart zum Stationsventil 72 ohne dazwischenliegende andere Ventile anzuordnen. Im gezeigten Ausführungsbeispiel sind alle Prozessgasventile 66, 67, 69 zwischen dem Bypassventil 73 und dem Stationsventil 72 angeordnet.

Die Verteilung des Prozessgases, die von den dargestellten Ventilen 66, 67, 69, 72, 73 beherrscht und z.B. von einer Steuereinrichtung 45 durch entsprechende Steuerbefehle in zeitlicher Hinsicht vorgegeben wird, erfolgt derart, dass das Prozessgas bei geöffnetem Stationsventil 72 in die Stationsbohrung 71 eintritt und zu einer Zweigstelle 75a gelangt, von der zwei Unterleitungen 1. Ordnung 76a, 76b abzweigen. An der Zweigstelle 75a teilt sich also der Prozessgasstrom auf und beide Teilströme werden zu den nicht dargestellten Gaslanzen 36 geführt und treten durch die Gaslanzen 36 hindurch in die Flaschen 5 aus. Die Stationsbohrung 71, die Zweigstelle 75a und die Unterleitungen 1. Ordnung 76a, 76b sind jeweils innerhalb des Verteilersockels 81 angeordnet und das Prozessgas wird also innerhalb des Verteilersockels 81 geführt und verteilt. Analog wie auch schon zur Figur 4 erklärt, erfüllen auch die in Figur 5 gezeigten Unterleitungen 1. Ordnung 76a, 76b und die Zweigstelle 75a bestimmte Symmetriebedingungen, weil dies die Geichverteilung der Prozessgase auf die mehreren Behälter 5 erleichtert. Die beiden Unterleitungen 1. Ordnung 76a und 76b verlaufen zu beiden Seiten der Achse X und können durch Spiegelung an einer Spiegelebene, innerhalb der die Achse X verläuft, ineinander überführt werden. Die beiden Leitungen weisen dadurch eine gleich Länge und einen gleichen Durchmesser auf, sodass gleiche Strömungswiderstände gegeben sind und die Aufteilung des Prozessgases an der Zweigstelle 75a paritätisch erfolgt, sodass beide Flaschen 5 symmetriebedingt gleichberechtigt mit Prozessgas versorgt werden.

Es ist möglich, in dem in Figur 4 gezeigten Ausführungsbeispiel den dortigen Kammerboden 29 analog zu dem in Figur 5 gezeigten Ventilträgerblock 80 auszubilden und mit dem in Figur 4 gezeigten beweglichen Ventilschlitten 37 zu kombinieren. Dazu müsste an den Kammerboden 29 auf der blickabgewandten Seite der Ventilträgerkörper 82 angeordnet werden, sodass die Stationsleitung 70 sich senkrecht zur eingezeichneten Achse X von der Rückseite des Kammerbodens 29 nach hinten weg laufend erstrecken würde und entlang dieser Erstreckung die vorstehend beschriebenen Ventile 66, 67, 69, 72, 73 angeordnet wären.

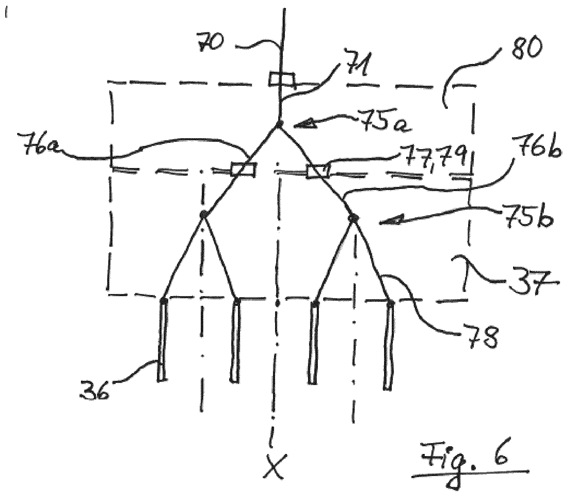

Fig. 6 zeigt eine vereinfachende Prinzipdarstellung zu einem weiteren erfindungsgemäßen Ausführungsbeispiel. Rein schematisch ist dargestellt, wie ausgehend von der Stationsleitung 70 das Prozessgas zu einer ersten Zweigstelle 75a gelangt und sich das Prozessgas auf die beiden Unterleitungen 1. Ordnung 76a und 76b aufteilt. Diese Unterleitungen 1. Ordnung verlaufen bis zu den Zweigstellen 2. Ordnung 75b, entsprechend gibt es zwei Zweigstellen 2. Ordnung. Auch an diesen Zweigstellen 2. Ordnung erfolgt eine Aufteilung in Unterleitungen, nämlich in insgesamt vier Unterleitungen 2. Ordnung 78. Diesen vier Unterleitungen 2. Ordnung schließen sich die Gaslanzen 36 an, über die Flaschen 5 mit Prozessgas versorgt werden. Es ist erfindungsgemäß besonders bevorzugt, wenn diese kaskadenartige Aufteilung des Prozessgases zumindest teilweise, bevorzugt vollständig im Lanzenschlitten 37 und/oder im Ventilträgerblock stattfindet. Entsprechend ist in der Figur 6 in Strömungsrichtung des Prozessgases der Ventilträgerblock 80 als erstes angeordnet, d. h. die Stationsleitung 70 führt das Prozessgas in diesen Block 80 hinein. Innerhalb dieses Blockes 80 erfolgt eine Aufteilung einer Einzelleitung auf mehrere Teilleitungen, vorliegend auf zwei Teilleitungen. Im gezeigten Ausführungsbeispiel laufen diese Teilleitungen 76a, 76b dann vom Ventilträgerblock 80 zum Lanzenschlitten 37. Innerhalb dieses Lanzenschlittens 37 sind Zweigstellen 2. Ordnung 75b vorgesehen, zu denen die besagten Teilleitungen 1. Ordnung hinführen. An den Zweigstellen 2. Ordnung 75b spalten sich die besagten Teilleitungen 1. Ordnung auf, bevorzugt und erneut jeweils zweifach, sodass in Richtung der Gaslanzen 36 von den beiden Zweigstellen 2. Ordnung insgesamt vier Unterleitungen 2. Ordnung 78 weglaufen, jeweils paarweise einer der beiden Zweigstellen 2. Ordnung 75b zuordenbar. Die Ausbildung der Zweigstellen innerhalb des Ventilträgerblockes 80 und/oder innerhalb des Lanzenschlittens 37 ergibt eine besondere gute Kompaktheit und ist deshalb in allen beschriebenen Varianten eine bevorzugte Ausführungsform. Insbesondere wird als vorteilhaft angesehen, dass sowohl der Ventilträgerblock 80 als auch der Gaslanzenschlitten 37 mit jeweiligen Zweigstellen75a bzw. 75b ausgeführt sind, und dass zwischen diesen beiden Elementen ein Prozessgasübertritt in abgedichteter Weise erfolgt und entsprechende Dichtungseinrichtungen 77, 79 an den einander zugewandten Seiten dieser beiden Stationselemente ausgebildet sind.

Auch zur Figur 6 ist auf die dargestellten geometrischen Symmetrieverhältnisse hinzuweisen, nämlich dass die beschriebenen Zweigstellen und Unterleitungen, sowohl 1. und gegebenenfalls auch 2. Ordnung, symmetrisch bezüglich einer Achse X sind, sodass sich aus dieser Symmetrie eine symmetriebedingte Gleichverteilung des Prozessgases ergibt und ohne dass für diese Gleichverteilung weitere Maßnahmen getroffen werden müssten. In den Ausführungsbeispielen war gezeigt, dass zwischen dem Gaslanzenschlitten 37 und dem Ventilträgerblock 80 eine Höhenrelativbewegung stattfindet und die Oberseite des einen Elementes gegen die Unterseite des anderen Elementes zur Anlage kommt. Denkbar ist auch, dass die entsprechenden Körper seitlich aneinander vorbeibewegt werden und daher gegebenenfalls ein gasdichter Übergang an den einander zugewandten Seitenflächen dieser beteiligten Stationselemente erfolgt, wenn diese Stationselemente ihre Beschichtungsstellung einnehmen und Prozessgas in die Flaschen zugeführt werden muss.

In den Ausführungsbeispielen zu den Figuren 4-6 sind in den Teilleitungen 1. und/oder 2. Ordnung jeweils keine Ventile eingezeichnet, weil dies als bevorzugt und verallgemeinerungsfähig angesehen wird. In weiterer verallgemeinerungsfähiger Weise ist in diesen Ausführungsbeispielen die eingezeichnete Symmetrieachse zugleich auch die Stationsachse und/oder diese Symmetrieachse parallel zur Drehachse des Beschichtungsrades 2 angeordnet, auf dem die Beschichtungsstationen 1 angeordnet sind. In keinem der Ausführungsbeispiele sind Querleitungen eingezeichnet, die sich zwischen Teilleitungen der gleichen Ordnung erstrecken könnten. Grundsätzlich ist sind solche Querverbindungsleitungen für alle Ausführungsbeispiele aber denkbar und möglich. Zu allen Ausführungsbeispielen ist auch verallgemeinerungsfähig vorteilhaft, wenn die Summe der Leitungsquerschnitte aller Leitungen einer höheren Ordnung gleich oder größer als die Summe der Querschnitte aller Leitungen einer niedrigeren Ordnung ist, wobei insgesamt und verallgemeinerungsfähig bevorzugt ist, dass diese Summen der Querschnitte gleich oder größer als der Querschnitt der Stationsleitung 70 sind.

Für alle gezeigten prozessgasführenden Leitungen 70, 71, 76a, 76b, 78 ist vorteilhaft, diese strömungsoptimiert auszulegen. Es wird darunter verstanden, dass diese in einer Geometrie vorgesehen werden, die Abrisskanten und Abrisswirbel vermeiden. Insbesondere sollen Richtungsänderungen mit kleinem Änderungsradius vermieden werden, sodass die in den Figuren 4 und 5 gezeigten Abwinklungen in den Leitungen nicht als strömungsoptimiert anzusehen sind. In dieser Hinsicht ist die Anordnung in Figur 6 vorteilhafter.

## Patentansprüche

1. Beschichtungsstation (1) für die gleichzeitige Innenbeschichtung von mehreren Behältern (5) in einem auf der Beschichtungsstation (1) ablaufenden Beschichtungsverfahren, insbesondere mittels eines PECVD-Verfahrens, insbesondere mittels eines mikrowelleninduzierten PECVD-Verfahrens,
wobei die Beschichtungsstation (1) eine Beschichtungskammer (17) aufweist, die in einen geöffneten und einen geschlossenen Zustand überführbar ist und in die die mehreren zu beschichtenden Behälter (5) anordenbar sind zum Zwecke der gleichzeitigen Beschichtung, wobei die Kammer (17) von Kammerwänden (18, 29) gebildet ist, die bevorzugt Dichteinrichtungen (41) aufweisen, wobei die Kammer (17) dadurch im geschlossenen Zustand abgedichtet gegen die Außenumgebung verschließbar ausgeführt ist,
und wobei in der Kammer (17) bevorzugt Halte- und Dichtmittel (28) angeordnet sind, die ausgebildet sind, die mehreren Behälter (5) innerhalb der Kammer (17) sowohl gegenüber der Umgebung als auch gegenüber der umgebenden Kammer (17) abgedichtet zu halten,
wobei die Beschichtungsstation (1) eine Stationsleitung (70) mit einem Stationsventil (72) aufweist für den ventilbeherrschten Anschluss an wenigstens eine Prozessgasquelle (44), wobei die Beschichtungsstation (1) für jeden der mehreren Behälter (5) jeweils eine zugeordnete Gaslanze (36) aufweist, die jeweils in einer Beschichtungsstellung in das Behälterinnere hineinragt und die jeweils in der Beschichtungsstellung über die Stationsleitung (70) mit der Prozessgasquelle (44) verbindbar ausgeführt ist,
wobei innerhalb der Station (1) kammerseitig des Stationsventils (72) eine von der Stationsleitung (70) abgehende Prozessgaszuführleitung (71, 76a, 76b, 78) zu den Gaslanzen (36) und damit zu den zugeordneten Behältern (5) verläuft, wobei die Zuführleitung an den Gaslanzen (36) endet und dort ihr Leitungsende aufweist, wobei sich diese Zuführleitung (71, 76a, 76b, 78) auf ihrer Erstreckung zwischen ihrem Anfang und ihrem Ende aufspaltet,
**dadurch gekennzeichnet, dass**
sich die Zuführleitung an wenigstens einer Zweigstelle (75a, 75b), die zwischen ihrem Leitungsanfang und ihrem Leitungsende angeordnet ist, in Teilleitungen (76a, 76b, 78) aufteilt, wobei jede der Teilleitungen (76a, 76b, 78) jeweils zu einer der Gaslanzen (36) verläuft, und wobei Länge und Durchmesser der Zuführleitung und der Teilleitungen (76a, 76b, 78) so gewählt sind, dass der Strömungswiderstand des Prozessgases ausgehend von dem Stationsventil (72) und durch jede jeweilige Teilleitung (76a, 76b, 78) hindurch bis zur jeweiligen Gaslanze (36) gleich ist, wobei in den Teilleitungen (76a, 76b, 78) bevorzugt keine Ventile angeordnet sind.

2. Beschichtungsstation (1) nach Anspruch 1, wobei die Station (1) ausgebildet ist für die gleichzeitige Beschichtung von 2" gleichen Behältern (5), mit n als natürlicher Zahl und n>1, die von 2" jeweils zugeordneten Gaslanzen (36) in ihrem Inneren mit Prozessgas versorgt werden, **dadurch gekennzeichnet, dass** sich die Zufuhrleitung an einer Zweigstelle 1. Ordnung (75a) in die Teilleitungen (76a, 76b) aufspaltet und sich diese jeweils an Zweigstellen 2. Ordnung (75b) weiter in Unterteilleitungen (78) aufspalten, und ggf. eine weitere Aufspaltung bis hin zu Zweigstellen n. Ordnung erfolgt, wobei die von den Zweigstellen der höchsten Ordnung n weggehenden Leitungen n. Ordnung (78) jeweils zu einer der Gaslanzen (36) und somit jeweils zu einem Behälter (5) führen, wobei die Länge und der Durchmesser der Leitungen n. Ordnung (78) so gewählt ist, dass der Strömungswiderstand des Prozessgases durch jede Leitung (78) gleich ist, wobei bevorzugt an jeder Zweigstelle (75a, 75b) eine Aufteilung in genau zwei nachgeordnete Leitungen (76a, 76b, 78) erfolgt und es Zweigstellen bis zur n. Ordnung gibt.

3. Beschichtungsstation (1) nach einem der vorhergehenden Ansprüche, **dadurch gekennzeichnet, dass** alle Teilleitungen (76a, 76b) und/oder Unterteilleitungen (78) untereinander einen gleichen Durchmesser und eine gleiche Länge aufweisen.

4. Beschichtungsstation (1) nach einem der vorhergehenden Ansprüche, **dadurch gekennzeichnet, dass** mehrere Gaslanzen (36), bevorzugt alle Gaslanzen (36), an einem gemeinsamen Lanzenschlitten (37) angeordnet sind, und der Lanzenschlitten (37) beweglich gegenüber der Stationskammer (17) ausgeführt ist, bevorzugt höhenbeweglich.

5. Beschichtungsstation (1) nach dem vorhergehenden Anspruch 4, **dadurch gekennzeichnet, dass** in dem Lanzenschlitten (37) zu den davon getragenen Gaslanzen (36) führende Teilleitungen (76a, 76b) oder Unterteilleitungen (78) ausgebildet sind, die in Strömungsverbindung mit der Gaslanze (36) stehen, wobei innerhalb des Lanzenschlittens (37) die Zweigstellen n. Ordnung (75b) angeordnet sind, wobei bevorzugt außerhalb des Lanzenschlitten die Zweigstellen (n-1). Ordnung (75a) angeordnet sind.

6. Beschichtungsstation (1) nach einem der vorhergehenden Ansprüche, **dadurch gekennzeichnet, dass** auf der Beschichtungsstation (1) und während des dort ablaufenden Beschichtungsverfahrens mehrere unterschiedliche Beschichtungen abgeschieden werden und unterschiedliche Prozessgase den Gaslanzen (36) zuführbar sind, wobei hierzu die Station (1) für jedes der Prozessgase eine jeweils von einem zugeordneten Prozessgasventil (66, 67, 69) beherrschte Prozessgasleitung (66', 67', 69`) aufweist, welche auf der kammerabgewandten Seite des Stationsventils (72) in die Stationsleitung (70) mündet.

7. Beschichtungsstation (1) nach Anspruch 6, **dadurch gekennzeichnet, dass** die mehreren Prozessgasventile (66, 67, 69) gemeinsam an einem Ventilträgerblock (80) angeordnet sind, der bevorzugt ortsfest mit der Beschichtungsstation (1) verbunden ist, wobei weiter bevorzugt auch das Stationsventil (70) an diesem Ventilträgerblock (80) angeordnet ist, wobei in diesem Fall weiter bevorzugt das Stationsventil (70) der Stationskammer (17) am nächsten liegend angeordnet ist.

8. Beschichtungsstation (1) nach Anspruch 7, **dadurch gekennzeichnet, dass** in dem Ventilträgerblock (80) Teilleitungen (76a, 76b) ausgebildet sind und eine erste Zweigstelle (75a) angeordnet ist und/oder wobei die Stationsleitung (70) wenigstens über eine Teillänge in dem Ventilträgerblock (80) ausgebildet ist.

9. Beschichtungsstation (1) nach einem der Ansprüche 7 oder 8, **dadurch gekennzeichnet, dass** an dem Ventilträgerblock (80) in Erstreckungsrichtung der Stationsleitung (70) mehrere Prozessgasventile (66, 67, 69) übereinandergestapelt angeordnet sind und die davon beherrschten Prozessgasleitungen (66', 67', 69') entlang der Erstreckungsrichtung in die Stationsleitung (70) einmünden, wobei bevorzugt auch das Stationsventil (72) an diesem Ventilträgerblock (80) angeordnet ist, wobei in diesem Fall weiter bevorzugt das Stationsventil (72) am der Stationskammer (17) zugewandten Ende der Stationsleitung (70) angeordnet ist.

10. Beschichtungsstation (1) nach einem der vorhergehenden Ansprüche 4 bis 9, **dadurch gekennzeichnet, dass** der Gaslanzenschlitten (37) in Längsrichtung der Gaslanzen (36) beweglich relativ zum Ventilträgerblock (80) ausgeführt ist.

11. Beschichtungsstation (1) nach einem der vorhergehenden Ansprüche 7 bis 10, **dadurch gekennzeichnet, dass** die Station (1) eine von einem Bypassventil (73) beherrschte Bypassleitung (83) aufweist, die in die Stationsleitung (70) mündet und über die die Stationsleitung (70) mit einer Unterdruckquelle (84) verbindbar ist, wobei das Bypassventil (73) an dem Ventilträgerblock (80) angeordnet ist, wobei die Beschichtungsstation (1) eine Steuereinrichtung (45) aufweist, die so ausgebildet und eingerichtet ist, dass das Bypassventil (73) unabhängig vom Stationsventil (72) betätigbar ist und das Stationsventil (72) und das Bypassventil (73) im Produktionsbetrieb der Station (1) alternierend zu öffnen und zu schließen, und um bei geöffnetem Bypassventil (73) wenigstens eines der Prozessgasventile (66, 67, 69) wenigstens zeitweise in den geöffneten Zustand zu steuern, wobei bevorzugt die Bypassleitung (83) weiter entfernt vom Stationsventil (72) als jede der Prozessgasleitungen (66', 67', 69') in die Stationsleitung (70) mündet.

12. Beschichtungsstation (1) nach einem der vorhergehenden Ansprüche, **dadurch gekennzeichnet, dass** die Station (1) auf einem Beschichtungsrad (2) angeordnet ist, das zu einem kontinuierlich drehenden Umlauf antreibbar ausgebildet und gelagert ist, wobei alle Zweigstellen (55a, 55b) in einem mit dem Beschichtungsrad (2) umlaufenden Bereich angeordnet sind, wobei bevorzugt mehrere solcher Stationen (1) auf dem Beschichtungsrad (2) angeordnet sind, bevorzugt in äquidistant umfangsverteilter Art.
